# EUROPEAN PATENT APPLICATION

(11) **EP 4 607 800 A2**
(43) Date of publication of application: **27.08.2025**
(21) Application number: 25162537.2
(22) Date of filing: 03.05.2018
(51) Int. Cl.: H03K 19/00

(54) **INTERFACE CIRCUIT**

(30) Priority: 30.11.2017 CN 201711236410
(62) Divisional of application: 18882461.9
(71) Applicant: Huawei Technologies Co., Ltd., Shenzhen, Guangdong 518129 (CN)
(72) Inventor: ZHOU, Yuzhen, Shenzhen, 518129 (CN); CAO, Wei, Shenzhen, 518129 (CN); FENG, Jun, Shenzhen, 518129 (CN); TAO, Yunbin, Shenzhen, 518129 (CN)
(74) Representative: Roth, Sebastian

(57) **Abstract**

This application discloses an interface circuit, and relates to the field of electronic technologies. The interface circuit includes a phase inverter. An input end of the phase inverter is connected to a signal output end of a first power domain circuit, and an output end of the phase inverter is connected to a signal input end of a second power domain circuit. A power end of the phase inverter is connected to a power supply of the first power domain circuit, and a ground end of the phase inverter is connected to a reference ground of the second power domain circuit. Alternatively, a power end of the phase inverter is connected to a power supply of the second power domain circuit, and a ground end of the phase inverter is connected to a reference ground of the first power domain circuit. When a voltage of the power end of the phase inverter of the interface circuit is greater than a voltage of the ground end of the phase inverter, correct transmission of a logical level of a signal can be ensured, thereby ensuring stability and reliability of a data transmission link between the first power domain circuit and the second power domain circuit, and enhancing an electrostatic interference resistance capability of a chip disposed with the interface circuit.

## Description

### TECHNICAL FIELD

This application relates to the field of electronic technologies, and in particular, to an interface circuit.

### BACKGROUND

With development of electronic technologies, to enable a chip to have more functions and consume less power, a plurality of power domain circuits are usually disposed in the chip. The plurality of power domain circuits use power supply solutions independent of each other, or in other words, the plurality of power domain circuits have different power supply circuits. Each power domain circuit has a turnover voltage. The turnover voltage of each power domain circuit is less than a voltage of a power supply of the power domain circuit and greater than a voltage of a reference ground of the power domain circuit. For an analog signal in a power domain circuit, if a voltage of the analog signal at a moment is greater than a turnover voltage of the power domain circuit, the analog signal is at a logical high level at this moment. If a voltage of the analog signal at a moment is smaller than the turnover voltage of the power domain circuit, the analog signal is at a logical low level at this moment. Generally, the logical high level is provided by a power supply of the power domain circuit, and the logical low level is provided by a reference ground of the power domain circuit.

In actual application, a signal cable, a power cable, a ground cable, and the like in the chip are prone to electrostatic interference in a plugging or unplugging process or in a normal working process. The voltage of the power supply and the voltage of the reference ground of each power domain circuit in the chip change greatly due to the electrostatic interference. Consequently, the turnover voltage of each power domain circuit changes greatly. For example, when a signal cable in a power domain circuit is interfered with by positive static electricity, both a voltage of a power supply and a voltage of a reference ground of the power domain circuit increase, and consequently, a turnover voltage of the power domain circuit also increases. Alternatively, when a signal cable in a power domain circuit is interfered with by negative static electricity, both a voltage of a power supply and a voltage of a reference ground of the power domain circuit decrease, and consequently, a turnover voltage of the power domain circuit also decreases.

In this case, if another power domain circuit transmits a signal to the power domain circuit interfered with by the static electricity, a logical level of the signal is very likely to be incorrectly transmitted. For example, a signal transmitted by a first power domain circuit to a second power domain circuit is at a logical high level. To be specific, a voltage of the signal is a voltage of a power supply of the first power domain circuit. In this case, if a turnover voltage of the second power domain circuit increases due to interference of positive static electricity and exceeds the voltage of the power supply of the first power domain circuit, the signal that is input from the first power domain circuit and that is originally at the logical high level is incorrectly considered to be at a logical low level in the second power domain circuit. For another example, a signal transmitted by the first power domain circuit to the second power domain circuit is at a logical low level. To be specific, a voltage of the signal is a voltage of a reference ground of the first power domain circuit. In this case, if a turnover voltage of the second power domain circuit decreases due to interference of negative static electricity and is smaller than the voltage of the reference ground of the first power domain circuit, the signal that is input from the first power domain circuit and that is originally at the logical low level is incorrectly considered to be at a logical high level in the second power domain circuit.

To resolve the foregoing problem, currently, an electrostatic discharge capability is usually added to the chip. For example, an electrostatic discharge (ESD) device, such as a transient voltage suppressor (Transient Voltage Suppressor, TVS) diode or a series resistor, may be added outside the chip to directly discharge outside the chip static electricity interfering with the chip, so that the static electricity does not affect an internal circuit of the chip. Alternatively, a quantity of output pins (pin) of the ground cable in the chip may be increased to enhance an electrostatic discharge capability of the ground cable, so that a voltage of the ground cable does not become excessively high or excessively low due to electrostatic interference. However, these methods all increase packaging costs and an area of the chip, thereby affecting an application range of the chip.

### SUMMARY

To resolve a problem in a related technology that a logical level of a signal is incorrectly transmitted, this application provides an interface circuit. The technical solutions are as follows:

According to a first aspect, an interface circuit is provided, including a phase inverter.

An input end of the phase inverter is connected to a signal output end of a first power domain circuit, and an output end of the phase inverter is connected to a signal input end of a second power domain circuit.

A power end of the phase inverter is connected to a power supply of the first power domain circuit, and a ground end of the phase inverter is connected to a reference ground of the second power domain circuit. Alternatively, a power end of the phase inverter is connected to a power supply of the second power domain circuit, and a ground end of the phase inverter is connected to a reference ground of the first power domain circuit.

Normally, a voltage of the power end of the phase inverter is greater than a voltage of the ground end of the phase inverter. In this case, if a voltage of the input end of the phase inverter is greater than a turnover voltage of the phase inverter, a voltage of the output end of the phase inverter is the voltage of the ground end of the phase inverter. If a voltage of the input end of the phase inverter is less than a turnover voltage of the phase inverter, a voltage of the output end of the phase inverter is the voltage of the power end of the phase inverter. The turnover voltage of the phase inverter is a voltage between the voltage of the power end of the phase inverter and the voltage of the ground end of the phase inverter.

It should be noted that the phase inverter is configured for transition between logical states of a signal. Specifically, the phase inverter is configured to: when an input signal is at a logical high level (that is, in a logical state "1"), output a signal at a logical low level (that is, in a logical state "0"), or when an input signal is at a logical low level, output a signal at a logical high level.

In addition, for a power domain circuit, a voltage of a signal that is output by the power domain circuit at a logical high level is a voltage of a power supply of the power domain circuit, and a voltage of a signal that is output by the power domain circuit at a logical low level is a voltage of a reference ground of the power domain circuit.

In this embodiment of the present invention, when the power end of the phase inverter is connected to the power supply of the first power domain circuit, and the ground end of the phase inverter is connected to the reference ground of the second power domain circuit, if a signal transmitted by the signal output end of the first power domain circuit to the input end of the phase inverter is at a logical high level, the voltage of the input end of the phase inverter is equal to the voltage of the power end of the phase inverter. Therefore, provided that a voltage, after increasing, of the reference ground of the second power domain circuit does not exceed the voltage of the power supply of the first power domain circuit, the voltage of the power end of the phase inverter is greater than the voltage of the ground end of the phase inverter, and the voltage of the input end of the phase inverter is greater than the turnover voltage of the phase inverter. In this case, the voltage of the output end of the phase inverter is the voltage of the ground end of the phase inverter. To be specific, a voltage of a signal transmitted by the output end of the phase inverter to the signal input end of the second power domain circuit is the voltage of the reference ground of the second power domain circuit. In this way, the signal that is input to the signal input end of the second power domain circuit is at a logical low level in the second power domain circuit, thereby ensuring correct transmission of the logical level of the signal.

In addition, when the power end of the phase inverter is connected to the power supply of the second power domain circuit, and the ground end of the phase inverter is connected to the reference ground of the first power domain circuit, if a signal transmitted by the signal output end of the first power domain circuit to the input end of the phase inverter is at a logical low level, the voltage of the input end of the phase inverter is equal to the voltage of the reference ground of the phase inverter. Therefore, provided that a voltage, after decreasing, of the power supply of the second power domain circuit is not smaller than the voltage of the reference ground of the first power domain circuit, the voltage of the power end of the phase inverter is greater than the voltage of the ground end of the phase inverter, and the voltage of the input end of the phase inverter is less than the turnover voltage of the phase inverter. In this case, the voltage of the output end of the phase inverter is the voltage of the power end of the phase inverter. To be specific, a voltage of a signal transmitted by the output end of the phase inverter to the signal input end of the second power domain circuit is the voltage of the power supply of the second power domain circuit. In this way, the signal that is input to the signal input end of the second power domain circuit is at a logical high level in the second power domain circuit, thereby ensuring correct transmission of the logical level of the signal.

The phase inverter includes a positive channel metal oxide semiconductor (positive channel Metal Oxide Semiconductor, PMOS) transistor and a negative channel metal oxide semiconductor (negative channel Metal Oxide Semiconductor, NMOS) transistor.

Both a gate of the PMOS transistor and a gate of the NMOS transistor are connected to the signal output end of the first power domain circuit. Both a drain of the PMOS transistor and a drain of the NMOS transistor are connected to the signal input end of the second power domain circuit.

A source of the PMOS transistor is connected to the power supply of the first power domain circuit, and a source of the NMOS transistor is connected to the reference ground of the second power domain circuit. Alternatively, a source of the PMOS transistor is connected to the power supply of the second power domain circuit, and a source of the NMOS transistor is connected to the reference ground of the first power domain circuit.

In this embodiment of the present invention, when the source of the PMOS transistor is connected to the power supply of the first power domain circuit, and the source of the NMOS transistor is connected to the reference ground of the second power domain circuit, if a signal transmitted by the signal output end of the first power domain circuit to the input end of the phase inverter is at a logical high level, voltages applied to the gate of the PMOS transistor and the gate of the NMOS transistor are the voltage of the power supply of the first power domain circuit. In this case, the voltage of the gate of the PMOS transistor is equal to a voltage of the source of the PMOS transistor, and the PMOS transistor is cut off. When a voltage, after increasing, of the reference ground of the second power domain circuit does not exceed the voltage of the power supply of the first power domain circuit, the voltage of the gate of the NMOS transistor is greater than a voltage of the source of the NMOS transistor, and the NMOS transistor is turned on. In this way, a voltage of a connection point between the drain of the PMOS transistor and the drain of the NMOS transistor is the voltage of the reference ground of the second power domain circuit connected to the source of the NMOS transistor. To be specific, a voltage of a signal that is input to the signal input end of the second power domain circuit is the voltage of the reference ground of the second power domain circuit.

In addition, when the source of the PMOS transistor is connected to the power supply of the second power domain circuit, and the source of the NMOS transistor is connected to the reference ground of the first power domain circuit, if a signal transmitted by the signal output end of the first power domain circuit to the input end of the phase inverter is at a logical low level, voltages applied to the gate of the PMOS transistor and the gate of the NMOS transistor are the voltage of the reference ground of the first power domain circuit. In this case, the voltage of the gate of the NMOS transistor is equal to the voltage of the source of the NMOS transistor, and the NMOS transistor is cut off. When a voltage, after decreasing, of the power supply of the second power domain circuit is not smaller than the voltage of the reference ground of the first power domain circuit, the voltage of the gate of the PMOS transistor is less than the voltage of the source of the PMOS transistor, and the PMOS transistor is turned on. In this way, the voltage of the connection point between the drain of the PMOS transistor and the drain of the NMOS transistor is the voltage of the power supply of the second power domain circuit connected to the source of the PMOS transistor. To be specific, a voltage of a signal that is input to the signal input end of the second power domain circuit is the voltage of the power supply of the second power domain circuit.

According to a second aspect, an interface circuit is provided, including a NAND gate circuit.

n input ends of the NAND gate circuit are respectively connected to n signal output ends of a plurality of power domain circuits, and an output end of the NAND gate circuit is connected to a signal input end of a target power domain circuit. The n input ends of the NAND gate circuit one-to-one correspond to n power ends of the NAND gate circuit, and n is an integer greater than or equal to 2.

An i^{th} power end of the n power ends of the NAND gate circuit is connected to a power supply of a power domain circuit to which an i^{th} signal output end of the n signal output ends belongs, a ground end of the NAND gate circuit is connected to a reference ground of the target power domain circuit, and i is an integer greater than or equal to 1 and less than or equal to n. Alternatively, the n power ends of the NAND gate circuit are all connected to a power supply of the target power domain circuit, and a ground end of the NAND gate circuit is connected to a reference ground of a power domain circuit to which a target signal output end of the n signal output ends belongs, and the target signal output end is connected to a target input end of the n input ends of the NAND gate circuit.

Normally, a voltage of each of the n power ends of the NAND gate circuit is greater than a voltage of the ground end of the NAND gate circuit. In this case, if a voltage of each of the n input ends of the NAND gate circuit is greater than a turnover voltage of the NAND gate circuit, a voltage of the output end of the NAND gate circuit is the voltage of the ground end of the NAND gate circuit. If a voltage of the target input end of the NAND gate circuit is less than the turnover voltage of the NAND gate circuit, the voltage of the output end of the NAND gate circuit is a voltage of a target power end that is in the n power ends of the NAND gate circuit and that is corresponding to the target input end. The turnover voltage of the NAND gate circuit is a voltage between the voltage of the ground end of the NAND gate circuit and a smallest voltage of voltages of the n power ends of the NAND gate circuit.

It should be noted that the NAND gate circuit is configured for transition between logical states of a signal. Specifically, the NAND gate circuit is configured to: when a plurality of input signals are all at a logical high level, output a signal at a logical low level, or when any one of a plurality of input signals is at a logical low level, output a signal at a logical high level.

In this embodiment of the present invention, when the i^{th} power end of the n power ends of the NAND gate circuit is connected to the power supply of the power domain circuit to which the i^{th} signal output end of the n signal output ends belongs, and the ground end of the NAND gate circuit is connected to the reference ground of the target power domain circuit, if signals transmitted by the n signal output ends to the n input ends of the NAND gate circuit are all at a logical high level, a voltage of an i^{th} input end of the n input ends of the NAND gate circuit is equal to a voltage of the i^{th} power end of the NAND gate circuit. Therefore, provided that a voltage, after increasing, of the reference ground of the target power domain circuit does not exceed a voltage of a power supply of each of the plurality of power domain circuits, the voltage of each of the n power ends of the NAND gate circuit is greater than the voltage of the ground end of the NAND gate circuit, and the voltage of each of the n input ends of the NAND gate circuit is greater than the turnover voltage of the NAND gate circuit. In this case, the voltage of the output end of the NAND gate circuit is the voltage of the ground end of the NAND gate circuit. To be specific, a voltage of a signal transmitted by the output end of the NAND gate circuit to the signal input end of the target power domain circuit is the voltage of the reference ground of the target power domain circuit. In this way, the signal that is input to the signal input end of the target power domain circuit is at a logical low level in the target power domain circuit, thereby ensuring correct transmission of the logical level of the signal.

In addition, when the n power ends of the NAND gate circuit are all connected to the power supply of the target power domain circuit, and the ground end of the NAND gate circuit is connected to the reference ground of the power domain circuit to which the target signal output end of the n signal output ends belongs, if a signal transmitted by the target signal output end of the n signal output ends to the target input end of the n input ends of the NAND gate circuit is at a logical low level, the voltage of the target input end of the NAND gate circuit is equal to the voltage of the ground end of the NAND gate circuit. Therefore, provided that a voltage, after decreasing, of the power supply of the target power domain circuit is not smaller than the voltage of the power supply of each of the plurality of power domain circuits, the voltage of each of the n power ends of the NAND gate circuit is greater than the voltage of the ground end of the NAND gate circuit, and the voltage of the target input end of the NAND gate circuit is less than the turnover voltage of the NAND gate circuit. In this case, the voltage of the target input end of the NAND gate circuit is a voltage of a power end of the NAND gate circuit. To be specific, a voltage of a signal transmitted by the output end of the NAND gate circuit to the signal input end of the target power domain circuit is the voltage of the power supply of the target power domain circuit. In this way, the signal that is input to the signal input end of the target power domain circuit is at a logical high level in the target power domain circuit, thereby ensuring correct transmission of the logical level of the signal.

The NAND gate circuit includes n PMOS transistors and n NMOS transistors.

Both a gate of an i^{th} PMOS transistor of the n PMOS transistors and a gate of an i^{th} NMOS transistor of the n NMOS transistors are connected to the i^{th} signal output end. Both a drain of each of the n PMOS transistors and a drain of a first NMOS transistor of the n NMOS transistors are connected to the signal input end of the target power domain circuit.

A source of the i^{th} PMOS transistor is connected to the power supply of the power domain circuit to which the i^{th} signal output end belongs, the n NMOS transistors are connected in series, and a source of an n^{th} NMOS transistor of the n NMOS transistors is connected to the reference ground of the target power domain circuit. Alternatively, a source of each of the n PMOS transistors is connected to the power supply of the target power domain circuit, the n NMOS transistors are connected in series, and a source of the n^{th} NMOS transistor is connected to the reference ground of the power domain circuit to which the target signal output end belongs.

In this embodiment of the present invention, when the source of the i^{th} PMOS transistor is connected to the power supply of the power domain circuit to which the i^{th} signal output end belongs, the n NMOS transistors are connected in series, and the source of the n^{th} NMOS transistor of the n NMOS transistors is connected to the reference ground of the target power domain circuit, if signals transmitted by the n signal output ends to the n input ends of the NAND gate circuit are all at a logical high level, provided that a voltage, after increasing, of the reference ground of the target power domain circuit does not exceed the voltage of the power supply of each of the plurality of power domain circuits, the n PMOS transistors are all cut off, and the n NMOS transistors are all turned on. In this way, a voltage of a connection point between the drain of each of the n PMOS transistors and the drain of the first NMOS transistor is the voltage of the reference ground of the target power domain circuit connected to the source of the n^{th} NMOS transistor. To be specific, a voltage of a signal that is input to the signal input end of the target power domain circuit is the voltage of the reference ground of the target power domain circuit.

In addition, when the source of each of the n PMOS transistors is connected to the power supply of the target power domain circuit, the n NMOS transistors are connected in series, and the source of the n^{th} NMOS transistor is connected to the reference ground of the power domain circuit to which the target signal output end belongs, if a signal transmitted by the target signal output end of the n signal output ends to the target input end of the n input ends of the NAND gate circuit is at a logical low level, provided that a voltage, after decreasing, of the power supply of the target power domain circuit is not smaller than the voltage of the power supply of each of the plurality of power domain circuits, the n NMOS transistors are all cut off, and the n PMOS transistors are all turned on. In this way, the voltage of the connection point between the drain of each of the n PMOS transistors and the drain of the first NMOS transistor is the voltage of the power supply of the target power domain circuit connected to a source of a target PMOS transistor. To be specific, a voltage of a signal that is input to the signal input end of the target power domain circuit is the voltage of the power supply of the target power domain circuit.

According to a third aspect, an interface circuit is provided, including a NOR gate circuit.

m input ends of the NOR gate circuit are respectively connected to m signal output ends of a plurality of power domain circuits, and an output end of the NOR gate circuit is connected to a signal input end of a target power domain circuit. The m input ends of the NOR gate circuit one-to-one correspond to m ground ends of the NOR gate circuit, and m is an integer greater than or equal to 2.

A power end of the NOR gate circuit is connected to a power supply of a power domain circuit to which a target signal output end of the m signal output ends belongs, the m ground ends of the NOR gate circuit are all connected to a reference ground of the target power domain circuit, and the target signal output end is connected to a target input end of the m input ends of the NOR gate circuit. Alternatively, a power end of the NOR gate circuit is connected to a power supply of the target power domain circuit, a k^{th} ground end of the m ground ends of the NOR gate circuit is connected to a reference ground of a power domain circuit to which a k^{th} signal output end of the m signal output ends belongs, and k is an integer greater than or equal to 1 and less than or equal to m.

Normally, a voltage of the power end of the NOR gate circuit is greater than a voltage of each of the m ground ends of the NOR gate circuit. In this case, if a voltage of the target input end of the NOR gate circuit is greater than a turnover voltage of the NOR gate circuit, a voltage of the output end of the NOR gate circuit is a voltage of a target ground end that is in the m ground ends of the NOR gate circuit and that is corresponding to the target input end. If a voltage of each of the m input ends of the NOR gate circuit is less than the turnover voltage of the NOR gate circuit, the voltage of the output end of the NOR gate circuit is the voltage of the power end of the NOR gate circuit. The turnover voltage of the NOR gate circuit is a voltage between the voltage of the power end of the NOR gate circuit and a smallest voltage of voltages of the m ground ends of the NOR gate circuit.

It should be noted that the NOR gate circuit is configured for transition between logical states of a signal. Specifically, the NOR gate circuit is configured to: when any one of a plurality of input signals is at a logical high level, output a signal at a logical low level, or when a plurality of input signals are all at a logical low level, output a signal at a logical high level.

In this embodiment of the present invention, when the power end of the NOR gate circuit is connected to the power supply of the power domain circuit to which the target signal output end of the m signal output ends belongs, and the m ground ends of the NOR gate circuit are all connected to the reference ground of the target power domain circuit, if a signal transmitted by the target signal output end of the m signal output ends to the target input end of the m input ends of the NOR gate circuit is at a logical high level, the voltage of the target input end of the NOR gate circuit is equal to the voltage of the power end of the NOR gate circuit. Therefore, provided that a voltage, after increasing, of the reference ground of the target power domain circuit does not exceed the voltage of the power supply of each of the plurality of power domain circuits, the voltage of the power end of the NOR gate circuit is greater than the voltage of each of the m ground ends of the NOR gate circuit, and the voltage of the target input end of the NOR gate circuit is greater than the turnover voltage of the NOR gate circuit. In this case, the voltage of the output end of the NOR gate circuit is a voltage of a ground end of the NOR gate circuit. To be specific, a voltage of a signal transmitted by the output end of the NOR gate circuit to the signal input end of the target power domain circuit is the voltage of the reference ground of the target power domain circuit. In this way, the signal that is input to the signal input end of the target power domain circuit is at a logical low level in the target power domain circuit, thereby ensuring correct transmission of the logical level of the signal.

In addition, when the power end of the NOR gate circuit is connected to the power supply of the target power domain circuit, and the k^{th} ground end of the m ground ends of the NOR gate circuit is connected to the reference ground of the power domain circuit to which the k^{th} signal output end of the m signal output ends belongs, if signals transmitted by the m signal output ends to the m input ends of the NOR gate circuit are all at a logical low level, a voltage of a k^{th} input end of the NOR gate circuit is equal to a voltage of the k^{th} ground end of the NOR gate circuit. Therefore, provided that a voltage, after decreasing, of the power supply of the target power domain circuit is not smaller than the voltage of the reference ground of each of the plurality of power domain circuits, the voltage of the power end of the NOR gate circuit is greater than the voltage of each of the m ground ends of the NOR gate circuit, and the voltage of each of the m input ends of the NOR gate circuit is less than the turnover voltage of the NOR gate circuit. In this case, the voltage of the output end of the NOR gate circuit is the voltage of the power end of the NOR gate circuit. To be specific, a voltage of a signal transmitted by the output end of the NOR gate circuit to the signal input end of the target power domain circuit is the voltage of the power supply of the target power domain circuit. In this way, the signal that is input to the signal input end of the target power domain circuit is at a logical high level in the target power domain circuit, thereby ensuring correct transmission of the logical level of the signal.

The NOR gate circuit includes m PMOS transistors and m NMOS transistors.

Both a gate of a k^{th} PMOS transistor of the m PMOS transistors and a gate of a k^{th} NMOS transistor of the m NMOS transistors are connected to the k^{th} signal output end. Both a drain of an m^{th} PMOS transistor of the m PMOS transistors and a drain of each of the m NMOS transistors are connected to the signal input end of the target power domain circuit.

A source of a first PMOS transistor of the m PMOS transistors is connected to the power supply of the power domain circuit to which the target signal output end belongs, the m PMOS transistors are connected in series, and a source of each of the m NMOS transistors is connected to the reference ground of the target power domain circuit. Alternatively, a source of the first PMOS transistor is connected to the power supply of the target power domain circuit, the m PMOS transistors are connected in series, and a source of the k^{th} NMOS transistor is connected to the reference ground of the power domain circuit to which the k^{th} signal output end belongs.

In this embodiment of the present invention, when the source of the first PMOS transistor of the m PMOS transistors is connected to the power supply of the power domain circuit to which the target signal output end belongs, the m PMOS transistors are connected in series, and the source of each of the m NMOS transistors is connected to the reference ground of the target power domain circuit, if a signal transmitted by the target signal output end of the m signal output ends to the target input end of the m input ends of the NOR gate circuit is at a logical high level, provided that a voltage, after increasing, of the reference ground of the target power domain circuit does not exceed the voltage of the power supply of each of the plurality of power domain circuits, the m PMOS transistors are all cut off, and the m NMOS transistors are all turned on. In this way, a voltage of a connection point between the drain of the m^{th} PMOS transistor and the drain of each of the m NMOS transistors is the voltage of the reference ground of the target power domain circuit connected to a source of a target NMOS transistor. To be specific, a voltage of a signal that is input to the signal input end of the target power domain circuit is the voltage of the reference ground of the target power domain circuit.

In addition, when the source of the first PMOS transistor is connected to the power supply of the target power domain circuit, the m PMOS transistors are connected in series, and the source of the k^{th} NMOS transistor is connected to the reference ground of the power domain circuit to which the k^{th} signal output end belongs, if signals transmitted by the m signal output ends to the m input ends of the NOR gate circuit are all at a logical low level, provided that a voltage, after decreasing, of the power supply of the target power domain circuit is not smaller than the voltage of the reference ground of each of the plurality of power domain circuits, the m NMOS transistors are all cut off, and the m PMOS transistors are all turned on. In this way, the voltage of the connection point between the drain of the m^{th} PMOS transistor and the drain of each of the m NMOS transistors is the voltage of the reference ground of the target power domain circuit connected to a source of the m^{th} NMOS transistor. To be specific, a voltage of a signal that is input to the signal input end of the target power domain circuit is the voltage of the power supply of the target power domain circuit.

Beneficial effects brought by the technical solutions provided in this application are as follows: The input end of the phase inverter is connected to the signal output end of the first power domain circuit, and the output end of the phase inverter is connected to the signal input end of the second power domain circuit. In this case, if the power end of the phase inverter is connected to the power supply of the first power domain circuit, and the ground end of the phase inverter is connected to the reference ground of the second power domain circuit, when a signal transmitted by the signal output end of the first power domain circuit to the input end of the phase inverter is at a logical high level, the voltage of the input end of the phase inverter is equal to the voltage of the power end of the phase inverter. Therefore, even if the voltage of the reference ground of the second power domain circuit changes greatly due to electrostatic interference, provided that a voltage, after increasing, of the reference ground of the second power domain circuit does not exceed the voltage of the power supply of the first power domain circuit, the voltage of the power end of the phase inverter is greater than the voltage of the ground end of the phase inverter, and the voltage of the input end of the phase inverter is greater than the turnover voltage of the phase inverter. In this case, a voltage of a signal transmitted by the output end of the phase inverter to the signal input end of the second power domain circuit is the voltage of the reference ground of the second power domain circuit. In this way, the signal that is input to the signal input end of the second power domain circuit is at a logical low level in the second power domain circuit, thereby ensuring correct transmission of the logical level of the signal. If the power end of the phase inverter is connected to the power supply of the second power domain circuit, and the ground end of the phase inverter is connected to the reference ground of the first power domain circuit, when a signal transmitted by the signal output end of the first power domain circuit to the input end of the phase inverter is at a logical low level, the voltage of the input end of the phase inverter is equal to the voltage of the reference ground of the phase inverter. Therefore, even if the voltage of the power supply of the second power domain circuit changes greatly due to electrostatic interference, provided that a voltage, after decreasing, of the power supply of the second power domain circuit is not smaller than the voltage of the reference ground of the first power domain circuit, the voltage of the power end of the phase inverter is greater than the voltage of the ground end of the phase inverter, and the voltage of the input end of the phase inverter is less than the turnover voltage of the phase inverter. In this case, a voltage of a signal transmitted by the output end of the phase inverter to the signal input end of the second power domain circuit is the voltage of the power supply of the second power domain circuit. In this way, the signal that is input to the signal input end of the second power domain circuit is at a logical high level in the second power domain circuit, thereby ensuring correct transmission of the logical level of the signal.

### BRIEF DESCRIPTION OF DRAWINGS

FIG. 1A is a schematic diagram of a power domain circuit interfered with by positive static electricity according to an embodiment of the present invention;
FIG. 1B is a schematic diagram of a power domain circuit interfered with by negative static electricity according to an embodiment of the present invention;
FIG. 1C is a schematic diagram of voltage increases of a power supply and a reference ground according to an embodiment of the present invention;
FIG. 1D is a schematic diagram of voltage decreases of a power supply and a reference ground according to an embodiment of the present invention;
FIG. 2A is a schematic structural diagram of a first interface circuit according to an embodiment of the present invention;
FIG. 2B is a schematic structural diagram of a second interface circuit according to an embodiment of the present invention;
FIG. 2C is a schematic structural diagram of a third interface circuit according to an embodiment of the present invention;
FIG. 2D is a schematic structural diagram of a fourth interface circuit according to an embodiment of the present invention;
FIG. 3A is a schematic structural diagram of a fifth interface circuit according to an embodiment of the present invention;
FIG. 3B is a schematic structural diagram of a sixth interface circuit according to an embodiment of the present invention;
FIG. 3C is a schematic structural diagram of a seventh interface circuit according to an embodiment of the present invention;
FIG. 3D is a schematic structural diagram of an eighth interface circuit according to an embodiment of the present invention;
FIG. 4A is a schematic structural diagram of a ninth interface circuit according to an embodiment of the present invention;
FIG. 4B is a schematic structural diagram of a tenth interface circuit according to an embodiment of the present invention;
FIG. 4C is a schematic structural diagram of an eleventh interface circuit according to an embodiment of the present invention; and
FIG. 4D is a schematic structural diagram of a twelfth interface circuit according to an embodiment of the present invention.

Reference numerals:
1: phase inverter; 1a: input end of the phase inverter; 1b: output end of the phase inverter; 1c: power end of the phase inverter; 1d: ground end of the phase inverter; 2: first power domain circuit; 2a: signal output end of the first power domain circuit; vdd1: power supply of the first power domain circuit; vss1: reference ground of the first power domain circuit; 3: second power domain circuit; 3a: signal input end of the second power domain circuit; vdd2: power supply of the second power domain circuit; vss2: reference ground of the second power domain circuit;
4: NAND gate circuit; 4a: input end of the NAND gate circuit; 4at: target input end of the NAND gate circuit; 4b: output end of the NAND gate circuit; 4c: power end of the NAND gate circuit; 4cₜ: target power end of the NAND gate circuit; 4d: ground end of the NAND gate circuit; 5: power domain circuit; 5a: signal output end of the power domain circuit; Sat: target signal output end of the power domain circuit; 6: target power domain circuit; 6a: signal input end of the target power domain circuit; 7: NOR gate circuit; 7a: input end of the NOR gate circuit; 7at: target input end of the NOR gate circuit; 7b: output end of the NOR gate circuit; 7c: power end of the NOR gate circuit; 7d: ground end of the NOR gate circuit; 7dₜ: target ground end of the NOR gate circuit;
Q1: PMOS transistor; g1: gate of the PMOS transistor; s1: source of the PMOS transistor; d1: drain of the PMOS transistor; Q1ₜ: target PMOS transistor; g1ₜ: gate of the target PMOS transistor; s1ₜ: source of the target PMOS transistor; d1ₜ: drain of the target PMOS transistor; Q2: NMOS transistor; g2: gate of the NMOS transistor; s2: source of the NMOS transistor; d2: drain of the NMOS; Q2ₜ: target NMOS transistor; g2t: gate of the target NMOS transistor; s2ₜ: source of the target NMOS transistor; d2t: drain of the target NMOS transistor.

### DESCRIPTION OF EMBODIMENTS

To make the objectives, technical solutions, and advantages of this application clearer, the following further describes the implementations of this application in detail with reference to the accompanying drawings.

Before the embodiments of the present invention are described in detail, an application scenario of the embodiments of the present invention is described.

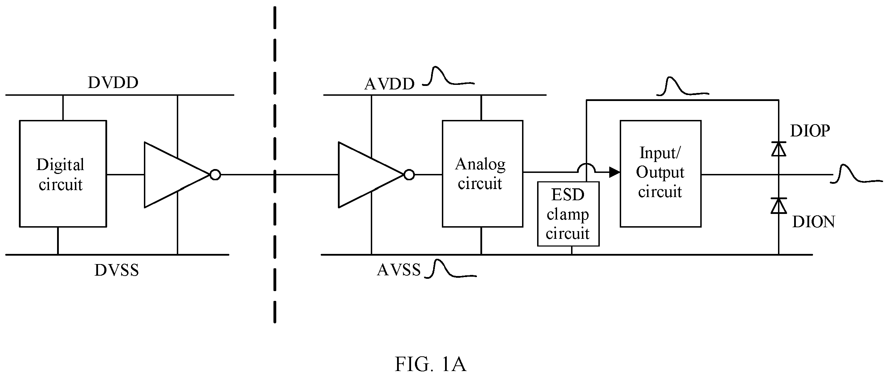

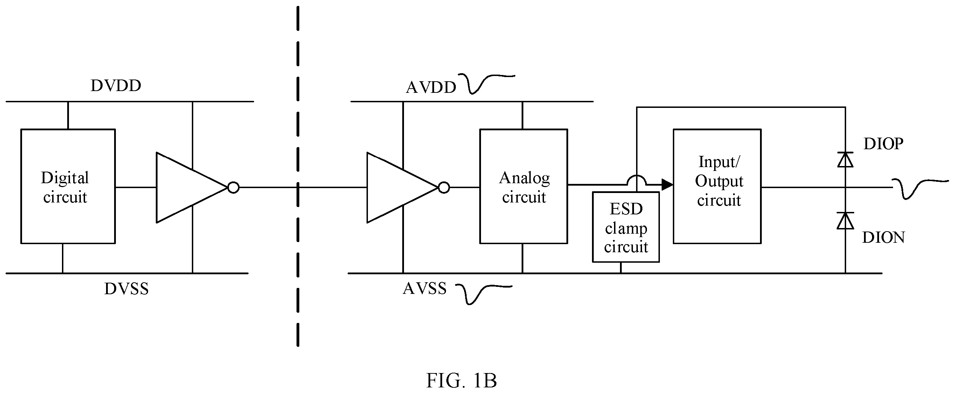

Currently, a signal cable, a power cable, a ground cable, and the like in a chip are prone to electrostatic interference in a plugging or unplugging process or in a normal working process. A voltage of a power supply and a voltage of a reference ground of each power domain circuit in the chip change greatly due to the electrostatic interference. For example, the chip includes a power domain circuit in which a digital circuit is located and a power domain circuit in which an analog circuit is located. It is assumed that a signal cable in the power domain circuit in which the analog circuit is located is interfered with by positive static electricity. As shown in FIG. 1A, the static electricity is transmitted to a reference ground AVSS of the power domain circuit by using a diode DIOP and an ESD clamp circuit. Consequently, a voltage of the reference ground AVSS increases. Because there are a comparatively large quantity of capacitors between a power supply AVDD of the power domain circuit and the reference ground AVSS, a voltage of the power supply AVDD increases with the voltage of the reference ground AVSS. It is also assumed that a signal cable in the power domain circuit in which the analog circuit is located is interfered with by negative static electricity. As shown in FIG. 1B, the static electricity is transmitted to the reference ground AVSS by using a diode DION. Consequently, the voltage of the reference ground AVSS decreases. When the voltage of the reference ground AVSS decreases, the voltage of the power supply AVDD decreases with the voltage of the reference ground AVSS.

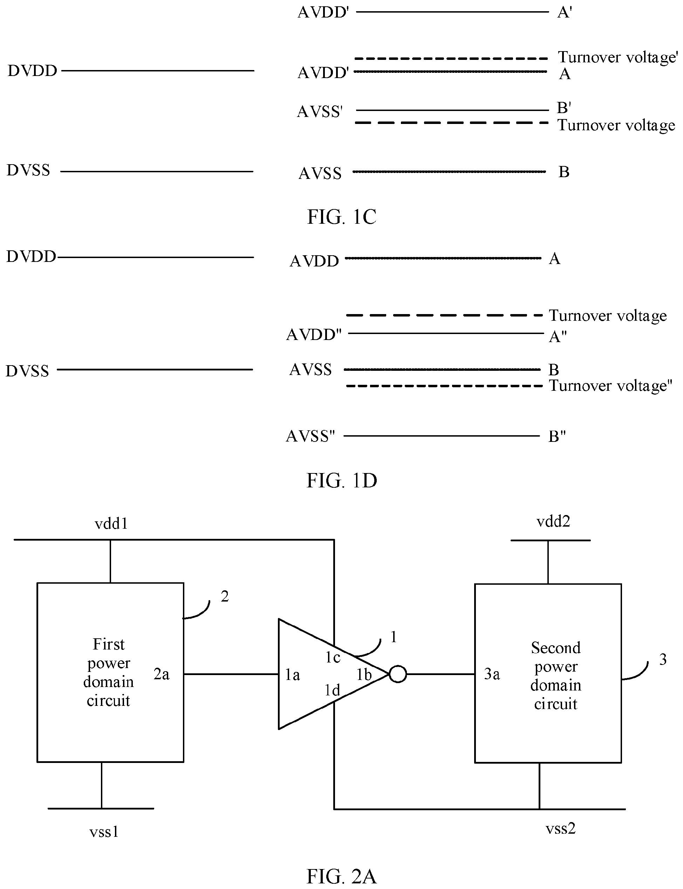

In this case, compared with a voltage of a power supply DVDD and a voltage of a reference ground DVSS of the power domain circuit in which the digital circuit is located, a turnover voltage of the power domain circuit in which the analog circuit is located changes more dramatically. For example, when the power domain circuit in which the analog circuit is located is interfered with by the positive static electricity in FIG. 1A, as shown in FIG. 1C, the voltage of the power supply AVDD may increase to a point A' instantaneously from a point A, and the voltage of the reference ground AVSS may increase to a point B' instantaneously from a point B. Consequently, the turnover voltage of the power domain circuit in which the analog circuit is located increases and exceeds the voltage of the power supply DVDD. For another example, when the power domain circuit in which the analog circuit is located is interfered with by the negative static electricity in FIG. 1B, as shown in FIG. 1D, the voltage of the power supply AVDD may decrease to a point A" instantaneously from the point A, and the voltage of the reference ground AVSS may decrease to a point B" instantaneously from the point B. Consequently, the turnover voltage of the power domain circuit in which the analog circuit is located decreases and is smaller than the voltage of the reference ground DVSS.

The increase or the decrease of the turnover voltage of the power domain circuit in which the analog circuit is located is very likely to cause an error to a logical level of a signal transmitted by the power domain circuit in which the digital circuit is located to the power domain circuit in which the analog circuit is located. For example, the signal transmitted by the power domain circuit in which the digital circuit is located to the power domain circuit in which the analog circuit is located is at a logical high level. To be specific, a voltage of the signal is the voltage of the power supply DVDD. In this case, if the turnover voltage of the power domain circuit in which the analog circuit is located increases and exceeds the voltage of the power supply DVDD due to the interference of the positive static electricity, the signal is incorrectly considered to be at a logical low level in the power domain circuit in which the analog circuit is located. For another example, the signal transmitted by the power domain circuit in which the digital circuit is located to the power domain circuit in which the analog circuit is located is at a logical low level. To be specific, a voltage of the signal is the voltage of the reference ground DVSS. In this case, if the turnover voltage of the power domain circuit in which the analog circuit is located decreases and is smaller than the voltage of the reference ground DVSS due to the interference of the negative static electricity, the signal is incorrectly considered to be at a logical high level in the power domain circuit in which the analog circuit is located.

It can be learned from the foregoing that when a signal transmitted by a power domain circuit to another power domain circuit that is interfered with by positive static electricity is at a logical high level, the logical level of the signal is very likely to be incorrectly transmitted at a logical low level; and when a signal transmitted by a power domain circuit to another power domain circuit that is interfered with by negative static electricity is at a logical low level, the logical level of the signal is very likely to be incorrectly transmitted at a logical high level. Incorrect transmission of a logical level of a signal is very likely to cause an incorrect change in internal state logic or a state of some registers in a power domain circuit receiving the signal. This causes an error to a data transmission link between power domain circuits in a chip, and affects working performance of the chip. Therefore, the embodiments of the present invention provide three interface circuits, to correctly transmit a logical level of a signal, thereby ensuring stability and reliability of a data transmission link between power domain circuits in a chip, and improving working performance of the chip.

It should be noted that voltages in the embodiments of the present invention are all determined based on a chip ground of a chip. For example, a voltage of a power supply of a power domain circuit is a potential difference between the power supply of the power domain circuit and a chip ground of a chip in which the power domain circuit is located, and a voltage of a reference ground of a power domain circuit is a potential difference between the reference ground of the power domain circuit and a chip ground of a chip in which the power domain circuit is located. Concepts of other voltages in the embodiments of the present invention are similar thereto, and details are not described herein.

The following describes in detail a first interface circuit provided in an embodiment of the present invention.

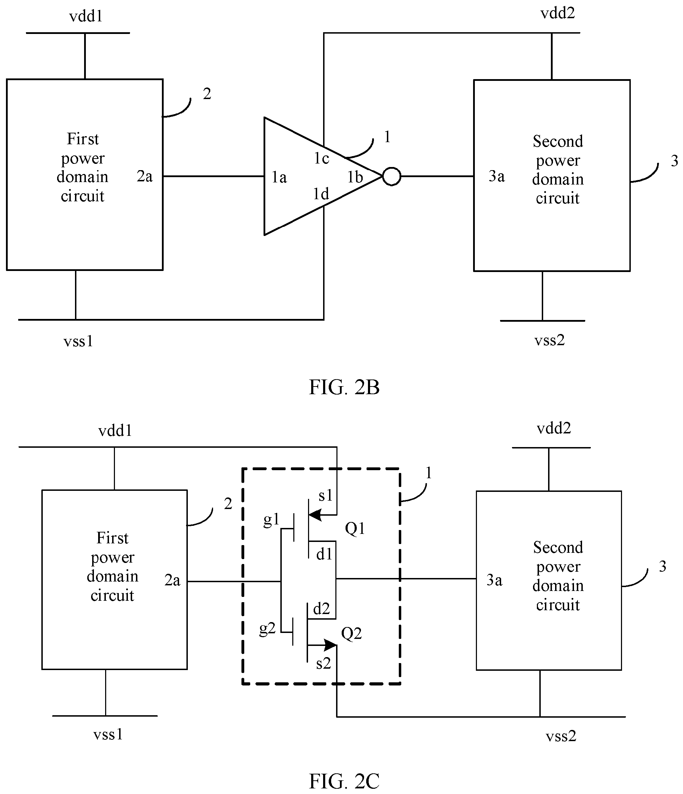

FIG. 2A and FIG. 2B are schematic structural diagrams of an interface circuit according to an embodiment of the present invention. Referring to FIG. 2A and FIG. 2B, the interface circuit includes a phase inverter 1.

An input end 1a of the phase inverter 1 is connected to a signal output end 2a of a first power domain circuit 2, and an output end 1b of the phase inverter 1 is connected to a signal input end 3a of a second power domain circuit 3.

Referring to FIG. 2A, a power end 1c of the phase inverter 1 is connected to a power supply vdd1 of the first power domain circuit 2, and a ground end 1d of the phase inverter 1 is connected to a reference ground vss2 of the second power domain circuit 3. Alternatively, referring to FIG. 2B, a power end 1c of the phase inverter 1 is connected to a power supply vdd2 of the second power domain circuit 3, and a ground end 1d of the phase inverter 1 is connected to a reference ground vss1 of the first power domain circuit 2.

Normally, a voltage of the power end 1c of the phase inverter 1 is greater than a voltage of the ground end 1d of the phase inverter 1. In this case, if a voltage of the input end 1a of the phase inverter 1 is greater than a turnover voltage of the phase inverter 1, a voltage of the output end 1b of the phase inverter 1 is the voltage of the ground end 1d of the phase inverter 1. If a voltage of the input end 1a of the phase inverter 1 is less than a turnover voltage of the phase inverter 1, a voltage of the output end 1b of the phase inverter 1 is the voltage of the power end 1c of the phase inverter 1.

It should be noted that the phase inverter 1 is configured for transition between logical states of a signal. Specifically, the phase inverter 1 is configured to: when an input signal is at a logical high level (that is, in a logical state "1"), output a signal at a logical low level (that is, in a logical state "0"), or when an input signal is at a logical low level, output a signal at a logical high level.

In addition, the turnover voltage of the phase inverter 1 is less than a first voltage of the phase inverter 1 and is greater than a second voltage of the phase inverter 1. The first voltage of the phase inverter 1 is a larger voltage of the voltage of the power end 1c of the phase inverter 1 and the voltage of the ground end 1d of the phase inverter 1. The second voltage of the phase inverter 1 is a smaller voltage of the voltage of the power end 1c of the phase inverter 1 and the voltage of the ground end 1d of the phase inverter 1. For example, the turnover voltage of the phase inverter 1 may be half of a sum of the voltage of the power end 1c of the phase inverter 1 and the voltage of the ground end 1d of the phase inverter 1.

It should be noted that the first power domain circuit 2 and the second power domain circuit 3 may be two different power domain circuits. To be specific, the first power domain circuit 2 and the second power domain circuit 3 use power supply solutions independent of each other, or in other words, a power supply circuit of the first power domain circuit 2 is different from a power supply circuit of the second power domain circuit 3.

In addition, for a power domain circuit, a voltage of a signal that is output by the power domain circuit at a logical high level is a voltage of a power supply of the power domain circuit, and a voltage of a signal that is output by the power domain circuit at a logical low level is a voltage of a reference ground of the power domain circuit. For example, if a signal that is output by the first power domain circuit 2 is at a logical high level, a voltage of the signal is a voltage of the power supply vdd1 of the first power domain circuit 2. For another example, if a signal that is output by the first power domain circuit 2 is at a logical low level, a voltage of the signal is a voltage of the reference ground vss1 of the first power domain circuit 2.

It should be noted that when the power end 1c of the phase inverter 1 is connected to the power supply vdd1 of the first power domain circuit 2, and the ground end 1d of the phase inverter 1 is connected to the reference ground vss2 of the second power domain circuit 3, the voltage of the power end 1c of the phase inverter 1 is the voltage of the power supply vdd1 of the first power domain circuit 2, and the voltage of the ground end 1d of the phase inverter 1 is a voltage of the reference ground vss2 of the second power domain circuit 3. In this case, when a signal transmitted by the signal output end 2a of the first power domain circuit 2 to the input end 1a of the phase inverter 1 is at a logical high level, the voltage of the input end 1a of the phase inverter 1 is the voltage of the power supply vdd1 of the first power domain circuit 2. In other words, the voltage of the input end 1a of the phase inverter 1 is equal to the voltage of the power end 1c of the phase inverter 1. Therefore, even if the voltage of the reference ground vss2 of the second power domain circuit 3 changes greatly due to electrostatic interference, provided that a voltage, after increasing, of the reference ground vss2 of the second power domain circuit 3 does not exceed the voltage of the power supply vdd1 of the first power domain circuit 2, the voltage of the power end 1c of the phase inverter 1 is greater than the voltage of the ground end 1d of the phase inverter 1, and the voltage of the input end 1a of the phase inverter 1 is greater than the turnover voltage of the phase inverter 1. In this case, the voltage of the output end 1b of the phase inverter 1 is the voltage of the ground end 1d of the phase inverter 1. To be specific, a voltage of a signal transmitted by the output end 1b of the phase inverter 1 to the signal input end 3a of the second power domain circuit 3 is the voltage of the reference ground vss2 of the second power domain circuit 3.

When the voltage of the signal transmitted by the output end 1b of the phase inverter 1 to the signal input end 3a of the second power domain circuit 3 is the voltage of the reference ground vss2 of the second power domain circuit 3, the signal that is input to the signal input end 3a of the second power domain circuit 3 is at a logical low level in the second power domain circuit 3. In this case, a signal that is input by the first power domain circuit 2 to the phase inverter 1 is at a logical high level, and then a signal that is input by the phase inverter 1 to the second power domain circuit 3 is at a logical low level, so that the logical level of the signal is correctly transmitted, thereby ensuring stability and reliability of a data transmission link between the first power domain circuit 2 and the second power domain circuit 3, enhancing an electrostatic interference resistance capability of a chip provided with the interface circuit, and improving working performance of the chip.

In addition, when the power end 1c of the phase inverter 1 is connected to the power supply vdd2 of the second power domain circuit 3, and the ground end 1d of the phase inverter 1 is connected to the reference ground vss1 of the first power domain circuit 2, the voltage of the power end 1c of the phase inverter 1 is the voltage of the power supply vdd2 of the second power domain circuit 3, and the voltage of the ground end 1d of the phase inverter 1 is the voltage of the reference ground vss1 of the first power domain circuit 2. In this case, when a signal transmitted by the signal output end 2a of the first power domain circuit 2 to the input end 1a of the phase inverter 1 is at a logical low level, the voltage of the input end 1a of the phase inverter 1 is the voltage of the reference ground vss1 of the first power domain circuit 2. In other words, the voltage of the input end 1a of the phase inverter 1 is equal to the voltage of the ground end 1d of the phase inverter 1. Therefore, even if the voltage of the power supply vdd2 of the second power domain circuit 3 changes greatly due to electrostatic interference, provided that a voltage, after decreasing, of the power supply vdd2 of the second power domain circuit 3 is not smaller than the voltage of the reference ground vss1 of the first power domain circuit 2, the voltage of the power end 1c of the phase inverter 1 is greater than the voltage of the ground end 1d of the phase inverter 1, and the voltage of the input end 1a of the phase inverter 1 is less than the turnover voltage of the phase inverter 1. In this case, the voltage of the output end 1b of the phase inverter 1 is the voltage of the power end 1c of the phase inverter 1. To be specific, a voltage of a signal transmitted by the output end 1b of the phase inverter 1 to the signal input end 3a of the second power domain circuit 3 is the voltage of the power supply vdd2 of the second power domain circuit 3.

When the voltage of the signal transmitted by the output end 1b of the phase inverter 1 to the signal input end 3a of the second power domain circuit 3 is the voltage of the power supply vdd2 of the second power domain circuit 3, the signal that is input to the signal input end 3a of the second power domain circuit 3 is at a logical high level in the second power domain circuit 3. In this case, a signal that is input by the first power domain circuit 2 to the phase inverter 1 is at a logical low level, and then a signal that is input by the phase inverter 1 to the second power domain circuit 3 is at a logical high level, so that the logical level of the signal is correctly transmitted, thereby ensuring stability and reliability of a data transmission link between the first power domain circuit 2 and the second power domain circuit 3, enhancing an electrostatic interference resistance capability of a chip provided with the interface circuit, and improving working performance of the chip.

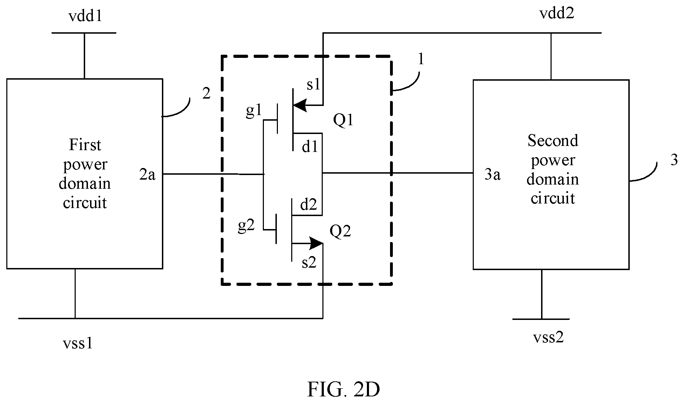

Referring to FIG. 2C and FIG. 2D, the phase inverter 1 includes a PMOS transistor Q1 and an NMOS transistor Q2.

Both a gate g1 of the PMOS transistor Q1 and a gate g2 of the NMOS transistor Q2 are connected to the signal output end 2a of the first power domain circuit 2. Both a drain d1 of the PMOS transistor Q1 and a drain d2 of the NMOS transistor Q2 are connected to the signal input end 3a of the second power domain circuit 3.

Referring to FIG. 2C, a source s1 of the PMOS transistor Q1 is connected to the power supply vdd1 of the first power domain circuit 2, and a source s2 of the NMOS transistor Q2 is connected to the reference ground vss2 of the second power domain circuit 3. Alternatively, referring to FIG. 2D, a source s1 of the PMOS transistor Q1 is connected to the power supply vdd2 of the second power domain circuit 3, and a source s2 of the NMOS transistor Q2 is connected to the reference ground vss1 of the first power domain circuit 2.

It should be noted that when the source s1 of the PMOS transistor Q1 is connected to the power supply vdd1 of the first power domain circuit 2, and the source s2 of the NMOS transistor Q2 is connected to the reference ground vss2 of the second power domain circuit 3, if a signal transmitted by the signal output end 2a of the first power domain circuit 2 to the input end 1a of the phase inverter 1 is at a logical high level, voltages applied to the gate g1 of the PMOS transistor Q1 and the gate g2 of the NMOS transistor Q2 are the voltage of the power supply vdd1 of the first power domain circuit 2. In this case, the voltage of the gate g1 of the PMOS transistor Q1 is equal to a voltage of the source s1 of the PMOS transistor Q1, and the PMOS transistor Q1 is cut off. When a voltage, after increasing, of the reference ground vss2 of the second power domain circuit 3 does not exceed the voltage of the power supply vdd1 of the first power domain circuit 2, the voltage of the gate g2 of the NMOS transistor Q2 is greater than a voltage of the source s2 of the NMOS transistor Q2, and the NMOS transistor Q2 is turned on. In this way, a voltage of a connection point between the drain d1 of the PMOS transistor Q1 and the drain d2 of the NMOS transistor Q2 is the voltage of the reference ground vss2 of the second power domain circuit 3 connected to the source s2 of the NMOS transistor Q2. To be specific, a voltage of a signal that is input to the signal input end 3a of the second power domain circuit 3 is the voltage of the reference ground vss2 of the second power domain circuit 3.

In addition, when the source s1 of the PMOS transistor Q1 is connected to the power supply vdd2 of the second power domain circuit 3, and the source s2 of the NMOS transistor Q2 is connected to the reference ground vss1 of the first power domain circuit 2, if a signal transmitted by the signal output end 2a of the first power domain circuit 2 to the input end 1a of the phase inverter 1 is at a logical low level, voltages applied to the gate g1 of the PMOS transistor Q1 and the gate g2 of the NMOS transistor Q2 are the voltage of the reference ground vss1 of the first power domain circuit 2. In this case, the voltage of the gate g2 of the NMOS transistor Q2 is equal to the voltage of the source s2 of the NMOS transistor Q2, and the NMOS transistor Q2 is cut off. When a voltage, after decreasing, of the power supply vdd2 of the second power domain circuit 3 is not smaller than the voltage of the reference ground vss1 of the first power domain circuit 2, the voltage of the gate g1 of the PMOS transistor Q1 is less than the voltage of the source s1 of the PMOS transistor Q1, and the PMOS transistor Q1 is turned on. In this way, the voltage of the connection point between the drain d1 of the PMOS transistor Q1 and the drain d2 of the NMOS transistor Q2 is the voltage of the power supply vdd2 of the second power domain circuit 3 connected to the source s1 of the PMOS transistor Q1. To be specific, a voltage of a signal that is input to the signal input end 3a of the second power domain circuit 3 is the voltage of the power supply vdd2 of the second power domain circuit 3.

In this embodiment of the present invention, the input end of the phase inverter is connected to the signal output end of the first power domain circuit, and the output end of the phase inverter is connected to the signal input end of the second power domain circuit. In this case, if the power end of the phase inverter is connected to the power supply of the first power domain circuit, and the ground end of the phase inverter is connected to the reference ground of the second power domain circuit, when a signal transmitted by the signal output end of the first power domain circuit to the input end of the phase inverter is at a logical high level, the voltage of the input end of the phase inverter is equal to the voltage of the power end of the phase inverter. Therefore, even if the voltage of the reference ground of the second power domain circuit changes greatly due to electrostatic interference, provided that a voltage, after increasing, of the reference ground of the second power domain circuit does not exceed the voltage of the power supply of the first power domain circuit, the voltage of the power end of the phase inverter is greater than the voltage of the ground end of the phase inverter, and the voltage of the input end of the phase inverter is greater than the turnover voltage of the phase inverter. In this case, a voltage of a signal transmitted by the output end of the phase inverter to the signal input end of the second power domain circuit is the voltage of the reference ground of the second power domain circuit. In this way, the signal that is input to the signal input end of the second power domain circuit is at a logical low level in the second power domain circuit, thereby ensuring correct transmission of the logical level of the signal. If the power end of the phase inverter is connected to the power supply of the second power domain circuit, and the ground end of the phase inverter is connected to the reference ground of the first power domain circuit, when a signal transmitted by the signal output end of the first power domain circuit to the input end of the phase inverter is at a logical low level, the voltage of the input end of the phase inverter is equal to the voltage of the reference ground of the phase inverter. Therefore, even if the voltage of the power supply of the second power domain circuit changes greatly due to electrostatic interference, provided that a voltage, after decreasing, of the power supply of the second power domain circuit is not smaller than the voltage of the reference ground of the first power domain circuit, the voltage of the power end of the phase inverter is greater than the voltage of the ground end of the phase inverter, and the voltage of the input end of the phase inverter is less than the turnover voltage of the phase inverter. In this case, a voltage of a signal transmitted by the output end of the phase inverter to the signal input end of the second power domain circuit is the voltage of the power supply of the second power domain circuit. In this way, the signal that is input to the signal input end of the second power domain circuit is at a logical high level in the second power domain circuit, thereby ensuring correct transmission of the logical level of the signal.

The following describes in detail a second interface circuit provided in an embodiment of the present invention.

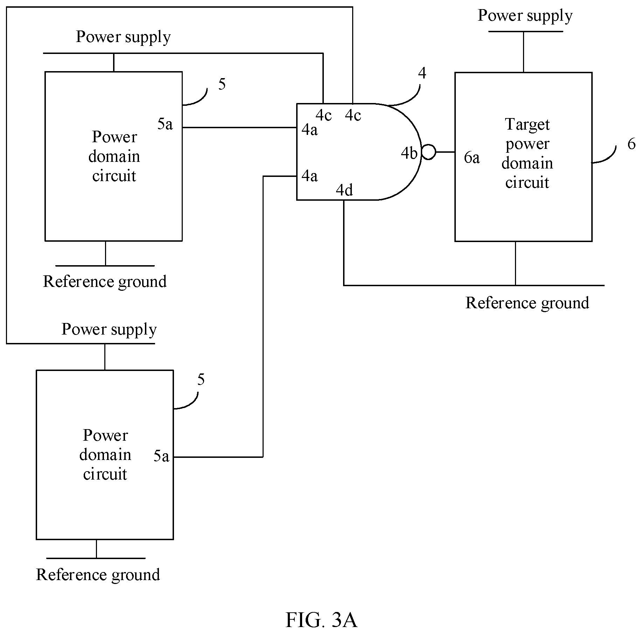

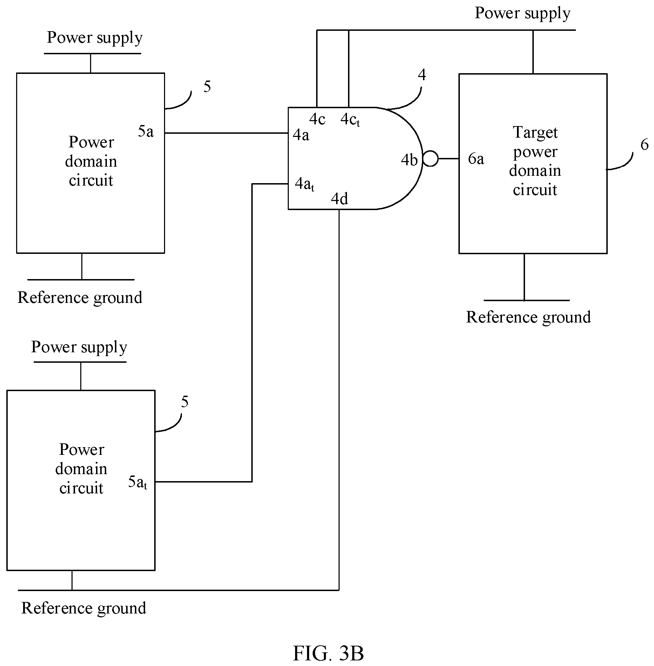

FIG. 3A and FIG. 3B are schematic structural diagrams of an interface circuit according to an embodiment of the present invention. Referring to FIG. 3A and FIG. 3B, the interface circuit includes a NAND gate circuit 4.

n input ends 4a of the NAND gate circuit 4 are respectively connected to n signal output ends 5a of a plurality of power domain circuits 5, and an output end 4b of the NAND gate circuit 4 is connected to a signal input end 6a of a target power domain circuit 6. The n input ends 4a of the NAND gate circuit 4 one-to-one correspond to n power ends 4c of the NAND gate circuit 4, and n is an integer greater than or equal to 2.

Referring to FIG. 3A, an i^{th} power end 4cᵢ of the n power ends 4c of the NAND gate circuit 4 is connected to a power supply of a power domain circuit to which an i^{th} signal output end 5aᵢ of the n signal output ends 5a belongs, a ground end 4d of the NAND gate circuit 4 is connected to a reference ground of the target power domain circuit 6, and i is an integer greater than or equal to 1 and less than or equal to n. Alternatively, referring to FIG. 3B, the n power ends 4c of the NAND gate circuit 4 are all connected to a power supply of the target power domain circuit 6, and a ground end 4d of the NAND gate circuit 4 is connected to a reference ground of a power domain circuit to which a target signal output end 5aₜ of the n signal output ends 5a belongs, and the target signal output end 5at is connected to a target input end 4at of the n input ends 4a of the NAND gate circuit 4.

Normally, a voltage of each of the n power ends 4c of the NAND gate circuit 4 is greater than a voltage of the ground end 4d of the NAND gate circuit 4. In this case, if a voltage of each of the n input ends 4a of the NAND gate circuit 4 is greater than a turnover voltage of the NAND gate circuit 4, a voltage of the output end 4b of the NAND gate circuit 4 is the voltage of the ground end 4d of the NAND gate circuit 4. If a voltage of the target input end 4at of the NAND gate circuit 4 is less than the turnover voltage of the NAND gate circuit 4, the voltage of the output end 4b of the NAND gate circuit 4 is a voltage of a target power end 4cₜ that is in the n power ends 4c of the NAND gate circuit 4 and that is corresponding to the target input end 4at.

It should be noted that the NAND gate circuit 4 is configured for transition between logical states of a signal. Specifically, the NAND gate circuit 4 is configured to: when a plurality of input signals are all at a logical high level, output a signal at a logical low level, or when any one of a plurality of input signals is at a logical low level, output a signal at a logical high level.

In addition, the turnover voltage of the NAND gate circuit 4 is less than a first voltage of the NAND gate circuit 4 and is greater than a second voltage of the NAND gate circuit 4. The first voltage of the NAND gate circuit 4 is a larger voltage of the voltage of the ground end 4d of the NAND gate circuit 4 and a smallest voltage of voltages of the n power ends 4c of the NAND gate circuit 4. The second voltage of the NAND gate circuit 4 is a smaller voltage of the voltage of the ground end 4d of the NAND gate circuit 4 and the smallest voltage of the voltages of the n power ends 4c of the NAND gate circuit 4. For example, the turnover voltage of the NAND gate circuit 4 may be half of a sum of the voltage of the ground end 4d of the NAND gate circuit 4 and the smallest voltage of the voltages of the n power ends 4c of the NAND gate circuit 4.

It should be noted that the plurality of power domain circuits 5 and the target power domain circuit 6 may be different power domain circuits. To be specific, the plurality of power domain circuits 5 and the target power domain circuit 6 use power supply solutions independent of each other, or in other words, power supply circuits of the plurality of power domain circuits 5 are different from a power supply circuit of the target power domain circuit 6. Each of the plurality of power domain circuits 5 may have at least one signal output end, and the plurality of power domain circuits 5 may have the n signal output ends in total.

In addition, for a power domain circuit, a voltage of a signal that is output by the power domain circuit at a logical high level is a voltage of a power supply of the power domain circuit, and a voltage of a signal that is output by the power domain circuit at a logical low level is a voltage of a reference ground of the power domain circuit. For example, if a signal that is output by any one of the plurality of power domain circuits 5 is at a logical high level, a voltage of the signal is a voltage of a power supply of the power domain circuit. For another example, if a signal that is output by any one of the plurality of power domain circuits 5 is at a logical low level, a voltage of the signal is a voltage of a reference ground of the power domain circuit.

It should be noted that when the i^{th} power end 4cᵢ of the n power ends 4c of the NAND gate circuit 4 is connected to the power supply of the power domain circuit to which the i^{th} signal output end 5aᵢ of the n signal output ends 5a belongs, and the ground end 4d of the NAND gate circuit 4 is connected to the reference ground of the target power domain circuit 6, a voltage of the i^{th} power end 4cᵢ of the NAND gate circuit 4 is a voltage of the power supply of the power domain circuit to which the i^{th} signal output end 5aᵢ belongs, and the voltage of the ground end 4d of the NAND gate circuit 4 is a voltage of the reference ground of the target power domain circuit 6. In this case, when signals transmitted by the n signal output ends 5a to the n input ends 4a of the NAND gate circuit 4 are all at a logical high level, a voltage of an i^{th} input end 4aᵢ of the n input ends 4a of the NAND gate circuit 4 is the voltage of the power supply of the power domain circuit to which the i^{th} signal output end 5aᵢ belongs. In other words, the voltage of the i^{th} input end 4aᵢ of the NAND gate circuit 4 is equal to the voltage of the i^{th} power end 4cᵢ of the NAND gate circuit 4. Therefore, even if the voltage of the reference ground of the target power domain circuit 6 changes greatly due to electrostatic interference, provided that a voltage, after increasing, of the reference ground of the target power domain circuit 6 does not exceed a voltage of a power supply of each of the plurality of power domain circuits 5, a voltage of each of the n power ends 4c of the NAND gate circuit 4 is greater than the voltage of the ground end 4d of the NAND gate circuit 4, and a voltage of each of the n input ends 4a of the NAND gate circuit 4 is greater than the turnover voltage of the NAND gate circuit 4. In this case, the voltage of the output end 4b of the NAND gate circuit 4 is the voltage of the ground end 4d of the NAND gate circuit 4. To be specific, a voltage of a signal transmitted by the output end 4b of the NAND gate circuit 4 to the signal input end 6a of the target power domain circuit 6 is the voltage of the reference ground of the target power domain circuit 6.

When the voltage of the signal transmitted by the output end 4b of the NAND gate circuit 4 to the signal input end 6a of the target power domain circuit 6 is the voltage of the reference ground of the target power domain circuit 6, the signal that is input to the signal input end 6a of the target power domain circuit 6 is at a logical low level in the target power domain circuit 6. In this case, signals that are input by the plurality of power domain circuits 5 to the NAND gate circuit 4 are all at a logical high level, and then a signal that is input by the NAND gate circuit 4 to the target power domain circuit 6 is at a logical low level, so that the logical level of the signal is correctly transmitted, thereby ensuring stability and reliability of data transmission links between the target power domain circuit 6 and the plurality of power domain circuits 5, enhancing an electrostatic interference resistance capability of a chip provided with the interface circuit, and improving working performance of the chip.

In addition, when the n power ends 4c of the NAND gate circuit 4 are all connected to the power supply of the target power domain circuit 6, and the ground end 4d of the NAND gate circuit 4 is connected to the reference ground of the power domain circuit to which the target signal output end 5at of the n signal output ends 5a belongs, the voltages of the n power ends 4c of the NAND gate circuit 4 are all the voltage of the power supply of the target power domain circuit 6, and the voltage of the ground end 4d of the NAND gate circuit 4 is a voltage of the reference ground of the power domain circuit to which the target signal output end 5at belongs. In this case, when a signal transmitted by the target signal output end 5at of the n signal output ends 5a to the target input end 4at of the n input ends 4a of the NAND gate circuit 4 is at a logical low level, the voltage of the target input end 4at of the NAND gate circuit 4 is the voltage of the reference ground of the power domain circuit to which the target signal output end 5at belongs. In other words, the voltage of the target input end 4at of the NAND gate circuit 4 is equal to the voltage of the ground end 4d of the NAND gate circuit 4. Therefore, even if the voltage of the power supply of the target power domain circuit 6 changes greatly due to electrostatic interference, provided that a voltage, after decreasing, of the power supply of the target power domain circuit 6 is not smaller than the voltage of the power supply of each of the plurality of power domain circuits 5, the voltage of each of the n power ends 4c of the NAND gate circuit 4 is greater than the voltage of the ground end 4d of the NAND gate circuit 4, and the voltage of the target input ends 4at of the NAND gate circuit 4 is smaller than the turnover voltage of the NAND gate circuit 4. In this case, the voltage of the output end 4b of the NAND gate circuit 4 is the voltage of the target power end 4ct that is in the n power ends 4c of the NAND gate circuit 4 and that is corresponding to the target input end 4at. To be specific, a voltage of a signal transmitted by the output end 4b of the NAND gate circuit 4 to the signal input end 6a of the target power domain circuit 6 is the voltage of the power supply of the target power domain circuit 6.

When the voltage of the signal transmitted by the output end 4b of the NAND gate circuit 4 to the signal input end 6a of the target power domain circuit 6 is the voltage of the power supply of the target power domain circuit 6, the signal that is input to the signal input end 6a of the target power domain circuit 6 is at a logical high level in the target power domain circuit 6. In this case, at least one of signals that are input by the plurality of power domain circuits 5 to the NAND gate circuit 4 is at a logical low level, and then a signal that is input by the NAND gate circuit 4 to the target power domain circuit 6 is at a logical high level, so that the logical level of the signal is correctly transmitted, thereby ensuring stability and reliability of data transmission links between the target power domain circuit 6 and the plurality of power domain circuits 5, enhancing an electrostatic interference resistance capability of a chip provided with the interface circuit, and improving working performance of the chip.

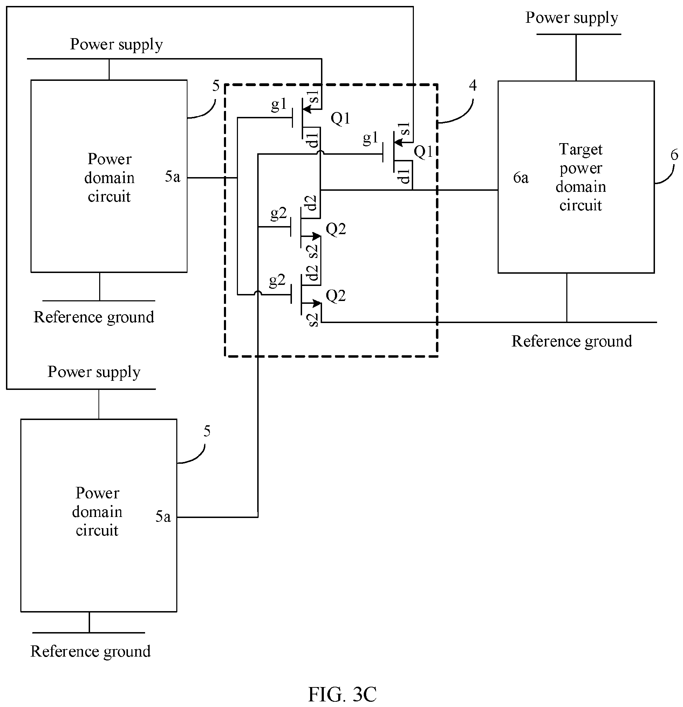

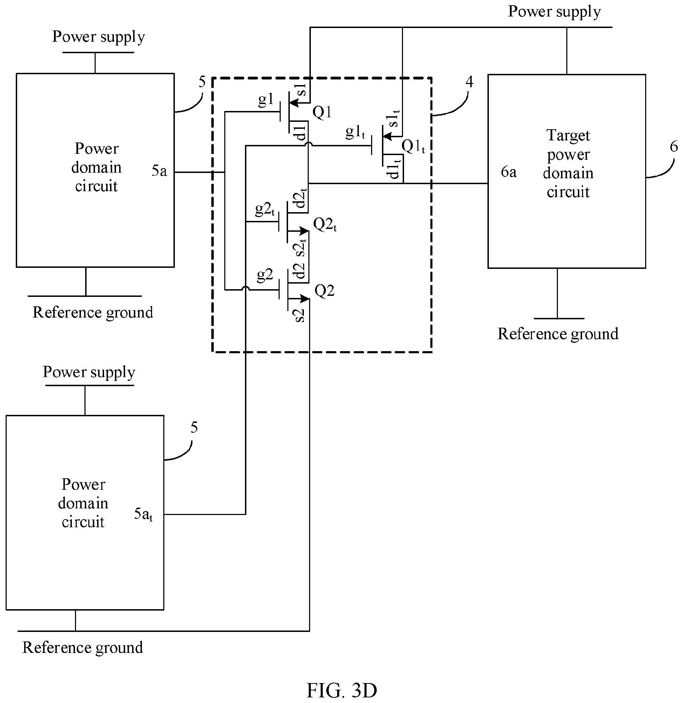

Referring to FIG. 3C and FIG. 3D, the NAND gate circuit 4 includes n PMOS transistors Q1 and n NMOS transistors Q2.

Both a gate g1ᵢ of an i^{th} PMOS transistor Q1ᵢ of the n PMOS transistors Q1 and a gate g2ᵢ of an i^{th} NMOS transistor Q2ᵢ of the n NMOS transistors Q2 are connected to the i^{th} signal output end 5aᵢ. Both a drain d1 of each of the n PMOS transistors Q1 and a drain d2₁ of a first NMOS transistor Q2₁ of the n NMOS transistors Q2 are connected to the signal input end 6a of the target power domain circuit 6.

Referring to FIG. 3C, a source s1ᵢ of the i^{th} PMOS transistor Q1ᵢ is connected to the power supply of the power domain circuit to which the i^{th} signal output end 5aᵢ belongs, the n NMOS transistors Q2 are connected in series, and a source s2ₙ of an n^{th} NMOS transistor Q2ₙ of the n NMOS transistors Q2 is connected to the reference ground of the target power domain circuit 6. Alternatively, referring to FIG. 3D, a source s1 of each of the n PMOS transistors Q1 is connected to the power supply of the target power domain circuit 6, the n NMOS transistors Q2 are connected in series, and a source s2ₙ of an n^{th} NMOS transistor Q2ₙ is connected to the reference ground of the power domain circuit to which the target signal output end 5at belongs.

It should be noted that when the source s1ᵢ of the i^{th} PMOS transistor Q1ᵢ is connected to the power supply of the power domain circuit to which the i^{th} signal output end 5aᵢ belongs, the n NMOS transistors Q2 are connected in series, and the source s2ₙ of the n^{th} NMOS transistor Q2ₙ of the n NMOS transistors Q2 is connected to the reference ground of the target power domain circuit 6, if a signal transmitted by the i^{th} signal output end 5aᵢ to the i^{th} input end 4aᵢ of the NAND gate circuit 4 is at a logical high level, voltages applied to the gate g1ᵢ of the i^{th} PMOS transistor Q1ᵢ and the gate g2ᵢ of the i^{th} NMOS transistor Q2ᵢ are the voltage of the power supply of the power domain circuit to which the i^{th} signal output end 5aᵢ belongs. In other words, the voltage of the gate g1ᵢ of the i^{th} PMOS transistor Q1ᵢ is equal to a voltage of the source s1ᵢ of the i^{th} PMOS transistor Q1ᵢ, and the i^{th} PMOS transistor Q1ᵢ is cut off. When a voltage, after increasing, of the reference ground of the target power domain circuit 6 does not exceed the voltage of the power supply of the power domain circuit to which the i^{th} signal output end 5aᵢ belongs, the voltage of the gate g2ᵢ of the i^{th} NMOS transistor Q2ᵢ is greater than a voltage of a source s2ᵢ of the i^{th} NMOS transistor Q2ᵢ, and the i^{th} NMOS transistor Q2ᵢ is turned on.

Therefore, when signals transmitted by the n signal output ends 5a to the n input ends 4a of the NAND gate circuit 4 are all at a logical high level, provided that a voltage, after increasing, of the reference ground of the target power domain circuit 6 does not exceed the voltage of the power supply of each of the plurality of power domain circuits 5, the n PMOS transistors Q1 are all cut off, and the n NMOS transistors Q2 are all turned on. In this way, a voltage of a connection point between the drain d1 of each of the n PMOS transistors Q1 and the drain d2₁ of the first NMOS transistor Q2₁ is the voltage of the reference ground of the target power domain circuit 6 connected to the source s2ₙ of the n^{th} NMOS transistor Q2ₙ. To be specific, a voltage of a signal that is input to the signal input end 6a of the target power domain circuit 6 is the voltage of the reference ground of the target power domain circuit 6.

In addition, when the source s1 of each of the n PMOS transistors Q1 is connected to the power supply of the target power domain circuit 6, the n NMOS transistors Q2 are connected in series, and the source s2ₙ of the n^{th} NMOS transistor Q2ₙ is connected to the reference ground of the power domain circuit to which the target signal output end 5at belongs, if a signal transmitted by the target signal output end 5at to the target input end 4at of the NAND gate circuit 4 is at a logical low level, voltages applied to a gate g1ₜ of a target PMOS transistor Q1ₜ of the n PMOS transistors Q1 connected to the target signal output end 5at and a gate g2ₜ of a target NMOS transistor Q2ₜ of the n NMOS transistors Q2 are the voltage of the reference ground of the power domain circuit to which the target signal output end 5at belongs. In this case, the voltage of the gate g2ₜ of the target NMOS transistor Q2ₜ is equal to a voltage of a source s2ₜ of the target NMOS transistor Q2ₜ, and the target NMOS transistor Q2ₜ is cut off. When a voltage, after decreasing, of the power supply of the target power domain circuit 6 is not smaller than the voltage of the reference ground of the power domain circuit to which the target signal output end 5at belongs, the voltage of the gate g1ₜ of the target PMOS transistor Q1ₜ is less than a voltage of a source s1ₜ of the target PMOS transistor Q1ₜ, and the target PMOS transistor Q1ₜ is turned on.

Therefore, when a signal transmitted by the target signal output ends 5at to the target input end 4at of the NAND gate circuit 4 is at a logical low level, provided that a voltage, after decreasing, of the power supply of the target power domain circuit 6 is not smaller than the voltage of the power supply of each of the plurality of power domain circuits 5, the n NMOS transistors Q2 are all cut off, and the n PMOS transistors Q1 are all turned on. In this way, the voltage of the connection point between the drain d1 of each of the n PMOS transistors Q1 and the drain d2₁ of the first NMOS transistor Q2₁ is the voltage of the power supply of the target power domain circuit 6 connected to the source s1ₜ of the target PMOS transistor Q1ₜ. To be specific, a voltage of a signal that is input to the signal input end 6a of the target power domain circuit 6 is the voltage of the power supply of the target power domain circuit 6.

In this embodiment of the present invention, the n input ends of the NAND gate circuit are respectively connected to the n signal output ends of the plurality of power domain circuits, and the output end of the NAND gate circuit is connected to the signal input end of the target power domain circuit. In this case, if the i^{th} power end of the n power ends of the NAND gate circuit is connected to the power supply of the power domain circuit to which the i^{th} signal output end of the n signal output ends belongs, and the ground end of the NAND gate circuit is connected to the reference ground of the target power domain circuit, when signals transmitted by the n signal output ends to the n input ends of the NAND gate circuit are all at a logical high level, the voltage of the i^{th} input end of the n input ends of the NAND gate circuit is equal to the voltage of the i^{th} power end of the NAND gate circuit. Therefore, even if the voltage of the reference ground of the target power domain circuit changes greatly due to electrostatic interference, provided that a voltage, after increasing, of the reference ground of the target power domain circuit does not exceed the voltage of the power supply of each of the plurality of power domain circuits, the voltage of each of the n power ends of the NAND gate circuit is greater than the voltage of the ground end of the NAND gate circuit, and the voltage of each of the n input ends of the NAND gate circuit is greater than the turnover voltage of the NAND gate circuit. In this case, a voltage of a signal transmitted by the output end of the NAND gate circuit to the signal input end of the target power domain circuit is the voltage of the reference ground of the target power domain circuit. In this way, the signal that is input to the signal input end of the target power domain circuit is at a logical low level in the target power domain circuit, thereby ensuring correct transmission of the logical level of the signal. If the n power ends of the NAND gate circuit are all connected to the power supply of the target power domain circuit, and the ground end of the NAND gate circuit is connected to the reference ground of the power domain circuit to which the target signal output end of the n signal output ends belongs, when a signal transmitted by the target signal output end to the target input end of the n input ends of the NAND gate circuit is at a logical low level, the voltage of the target input end of the NAND gate circuit is equal to the voltage of the ground end of the NAND gate circuit. Therefore, even if the voltage of the power supply of the target power domain circuit changes greatly due to electrostatic interference, provided that a voltage, after decreasing, of the power supply of the target power domain circuit is not smaller than the voltage of the power supply of each of the plurality of power domain circuits, the voltage of each of the n power ends of the NAND gate circuit is greater than the voltage of the ground end of the NAND gate circuit, and the voltage of the target input end of the NAND gate circuit is less than the turnover voltage of the NAND gate circuit. In this case, a voltage of a signal transmitted by the output end of the NAND gate circuit to the signal input end of the target power domain circuit is the voltage of the power supply of the target power domain circuit. In this way, the signal that is input to the signal input end of the target power domain circuit is at a logical high level in the target power domain circuit, thereby ensuring correct transmission of the logical level of the signal.

The following describes in detail a third interface circuit provided in an embodiment of the present invention.

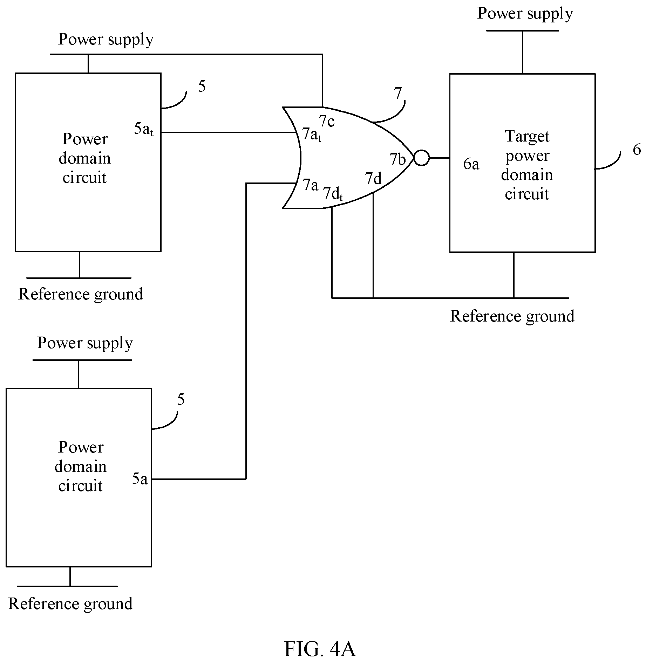

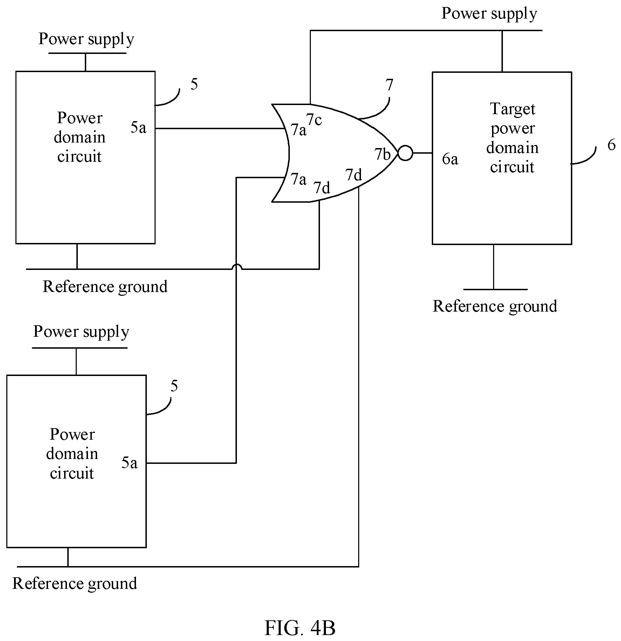

FIG. 4A and FIG. 4B are schematic structural diagrams of an interface circuit according to an embodiment of the present invention. Referring to FIG. 4A and FIG. 4B, the interface circuit includes a NOR gate circuit 7.

m input ends 7a of the NOR gate circuit 7 are respectively connected to m signal output ends 5a of a plurality of power domain circuits 5, and an output end 7b of the NOR gate circuit 7 is connected to a signal input end 6a of a target power domain circuit 6. The m input ends 7a of the NOR gate circuit 7 one-to-one correspond to m ground ends 7d of the NOR gate circuit 7, and m is an integer greater than or equal to 2.

Referring to FIG. 4A, a power end 7c of the NOR gate circuit 7 is connected to a power supply of a power domain circuit to which a target signal output end 5at of the m signal output ends 5a belongs, the m ground ends 7d of the NOR gate circuit 7 are all connected to a reference ground of the target power domain circuit 6, and the target signal output end 5at is connected to a target input end 7at of the m input ends 7a of the NOR gate circuit 7. Alternatively, referring to FIG. 4B, a power end 7c of the NOR gate circuit 7 is connected to a power supply of the target power domain circuit 6, a k^{th} ground end 7dₖ of the m ground ends 7d of the NOR gate circuit 7 is connected to a reference ground of a power domain circuit to which a k^{th} signal output end 5aₖ of the m signal output ends 5a belongs, and k is an integer greater than or equal to 1 and less than or equal to m.

Normally, a voltage of the power end 7c of the NOR gate circuit 7 is greater than a voltage of each of the m ground ends 7d of the NOR gate circuit 7. In this case, if a voltage of the target input end 7at of the NOR gate circuit 7 is greater than a turnover voltage of the NOR gate circuit 7, a voltage of the output end 7b of the NOR gate circuit 7 is a voltage of a target ground end 7dt that is in the m ground ends 7d of the NOR gate circuit 7 and that is corresponding to the target input end 7at. If a voltage of each of the m input ends 7a of the NOR gate circuit 7 is less than the turnover voltage of the NOR gate circuit 7, the voltage of the output end 7b of the NOR gate circuit 7 is the voltage of the power end 7c of the NOR gate circuit 7.

It should be noted that the NOR gate circuit 7 is configured for transition between logical states of a signal. Specifically, the NOR gate circuit 7 is configured to: when any one of a plurality of input signals is at a logical high level, output a signal at a logical low level, or when a plurality of input signals are all at a logical low level, output a signal at a logical high level.

In addition, the turnover voltage of the NOR gate circuit 7 is less than a first voltage of the NOR gate circuit 7 and is greater than a second voltage of the NOR gate circuit 7. The first voltage of the NOR gate circuit 7 is a larger voltage of the voltage of the power end 7c of the NOR gate circuit 7 and a smallest voltage of voltages of the m ground ends 7d of the NOR gate circuit 7. The second voltage of the NOR gate circuit 7 is a smaller voltage of the voltage of the power end 7c of the NOR gate circuit 7 and the smallest voltage of the voltages of the m ground ends 7d of the NOR gate circuit 7. For example, the turnover voltage of the NOR gate circuit 7 may be half of a sum of the voltage of the power end 7c of the NOR gate circuit 7 and the smallest voltage of the voltages of the m ground ends 7d of the NOR gate circuit 7.

It should be noted that the plurality of power domain circuits 5 and the target power domain circuit 6 may be different power domain circuits. To be specific, the plurality of power domain circuits 5 and the target power domain circuit 6 use power supply solutions independent of each other, or in other words, power supply circuits of the plurality of power domain circuits 5 are different from a power supply circuit of the target power domain circuit 6. Each of the plurality of power domain circuits 5 may have at least one signal output end, and the plurality of power domain circuits 5 may have the m signal output ends in total.

In addition, for a power domain circuit, a voltage of a signal that is output by the power domain circuit at a logical high level is a voltage of a power supply of the power domain circuit, and a voltage of a signal that is output by the power domain circuit at a logical low level is a voltage of a reference ground of the power domain circuit. For example, if a signal that is output by any one of the plurality of power domain circuits 5 is at a logical high level, a voltage of the signal is a voltage of a power supply of the power domain circuit. For another example, if a signal that is output by any one of the plurality of power domain circuits 5 is at a logical low level, a voltage of the signal is a voltage of a reference ground of the power domain circuit.

It should be noted that when the power end 7c of the NOR gate circuit 7 is connected to the power supply of the power domain circuit to which the target signal output end 5at of the m signal output ends 5a belongs, and the m ground ends 7d of the NOR gate circuit 7 are all connected to the reference ground of the target power domain circuit 6, the voltage of the power end 7c of the NOR gate circuit 7 is a voltage of the power supply of the power domain circuit to which the target signal output end 5at belongs, and voltages of the m ground ends 7d of the NOR gate circuit 7 are all the voltage of the reference ground of the target power domain circuit 6. In this case, when a signal transmitted by the target signal output end 5aₜ of the m signal output ends 5a to the target input end 7at of the m input ends 7a of the NOR gate circuit 7 is at a logical high level, the voltage of the target input end 7aₜ of the NOR gate circuit 7 is the voltage of the power supply of the power domain circuit to which the target signal output end 5at belongs. In other words, the voltage of the target input end 7at of the NOR gate circuit 7 is equal to the voltage of the power end 7c of the NOR gate circuit 7. Therefore, even if the voltage of the reference ground of the target power domain circuit 6 changes greatly due to electrostatic interference, provided that a voltage, after increasing, of the reference ground of the target power domain circuit 6 does not exceed a voltage of a power supply of each of the plurality of power domain circuits 5, the voltage of the power end 7c of the NOR gate circuit 7 is greater than the voltage of each of the m ground ends 7d of the NOR gate circuit 7, and the voltage of the target input end 7aₜ of the NOR gate circuit 7 is greater than the turnover voltage of the NOR gate circuit 7. In this case, the voltage of the output end 7b of the NOR gate circuit 7 is the voltage of the target ground end 7dt that is in the m ground ends 7d of the NOR gate circuit 7 and that is corresponding to the target input end 7at. To be specific, a voltage of a signal transmitted by the output end 7b of the NOR gate circuit 7 to the signal input end 6a of the target power domain circuit 6 is the voltage of the reference ground of the target power domain circuit 6.

When the voltage of the signal transmitted by the output end 7b of the NOR gate circuit 7 to the signal input end 6a of the target power domain circuit 6 is the voltage of the reference ground of the target power domain circuit 6, the signal that is input to the signal input end 6a of the target power domain circuit 6 is at a logical low level in the target power domain circuit 6. In this case, at least one of signals that are input by the plurality of power domain circuits 5 to the NOR gate circuit 7 is at a logical high level, and then a signal that is input by the NOR gate circuit 7 to the target power domain circuit 6 is at a logical low level, so that the logical level of the signal is correctly transmitted, thereby ensuring stability and reliability of data transmission links between the target power domain circuit 6 and the plurality of power domain circuits 5, enhancing an electrostatic interference resistance capability of a chip provided with the interface circuit, and improving working performance of the chip.

In addition, when the power end 7c of the NOR gate circuit 7 is connected to the power supply of the target power domain circuit 6, and the k^{th} ground end 7dₖ of the m ground ends 7d of the NOR gate circuit 7 is connected to the reference ground of the power domain circuit to which the k^{th} signal output end 5aₖ of the m signal output ends 5a belongs, the voltage of the power end 7c of the NOR gate circuit 7 is the voltage of the power supply of the target power domain circuit 6, and a voltage of the k^{th} ground end 7dₖ of the m ground ends 7d of the NOR gate circuit 7 is the voltage of the reference ground of the power domain circuit to which the k^{th} signal output end 5aₖ of the m signal output ends 5a belongs. In this case, when signals transmitted by the m signal output ends 5a to the m input ends 7a of the NOR gate circuit 7 are all at a logical low level, a voltage of a k^{th} input end 7aₖ of the m input ends 7a of the NOR gate circuit 7 is the voltage of the reference ground of the power domain circuit to which the k^{th} signal output end 5aₖ belongs. In other words, the voltage of the k^{th} input end 7aₖ of the NOR gate circuit 7 is equal to the voltage of the k^{th} ground end 7dₖ of the NOR gate circuit 7. Therefore, even if the voltage of the power supply of the target power domain circuit 6 changes greatly due to electrostatic interference, provided that a voltage, after decreasing, of the power supply of the target power domain circuit 6 is not smaller than a voltage of a reference ground of each of the plurality of power domain circuits 5, the voltage of the power end 7c of the NOR gate circuit 7 is greater than the voltage of each of the m ground ends 7d of the NOR gate circuit 7, and the voltage of each of the input ends 7a of the NOR gate circuit 7 is smaller than the turnover voltage of the NOR gate circuit 7. In this case, the voltage of the output end 7b of the NOR gate circuit 7 is the voltage of the power supply 7c of the NOR gate circuit 7. To be specific, a voltage of a signal transmitted by the output end 7b of the NOR gate circuit 7 to the signal input end 6a of the target power domain circuit 6 is the voltage of the power supply of the target power domain circuit 6.

When the voltage of the signal transmitted by the output end 7b of the NOR gate circuit 7 to the signal input end 6a of the target power domain circuit 6 is the voltage of the power supply of the target power domain circuit 6, the signal that is input to the signal input end 6a of the target power domain circuit 6 is at a logical high level in the target power domain circuit 6. In this case, signals that are input by the plurality of power domain circuits 5 to the NOR gate circuit 7 are all at a logical low level, and then a signal that is input by the NOR gate circuit 7 to the target power domain circuit 6 is at a logical high level, so that the logical level of the signal is correctly transmitted, thereby ensuring stability and reliability of data transmission links between the target power domain circuit 6 and the plurality of power domain circuits 5, enhancing an electrostatic interference resistance capability of a chip provided with the interface circuit, and improving working performance of the chip.

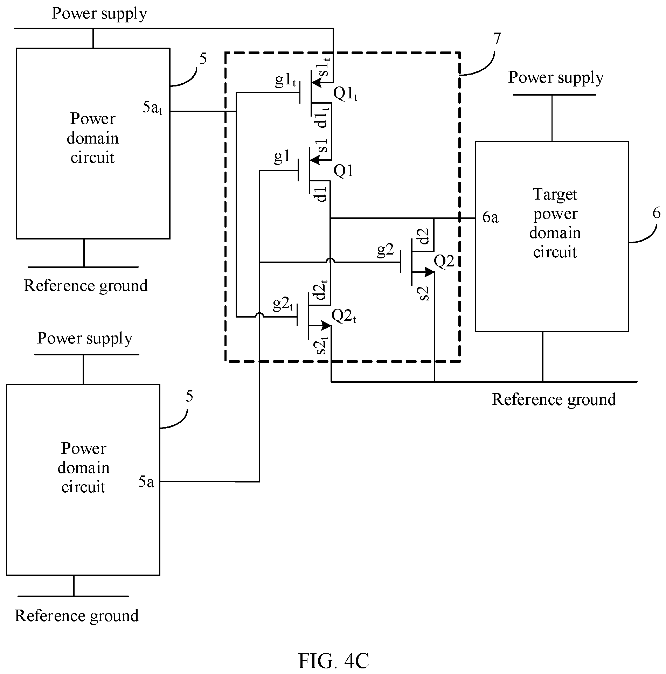

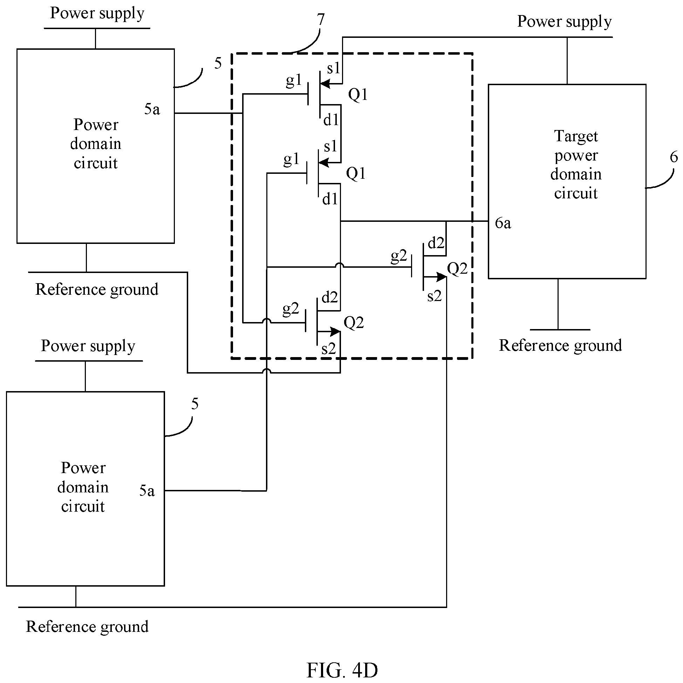

Referring to FIG. 4C and FIG. 4D, the NOR gate circuit 7 includes m PMOS transistors Q1 and m NMOS transistors Q2.

Both a gate g1ₖ of a k^{th} PMOS transistor Q1ₖ of the m PMOS transistors Q1 and a gate g2ₖ of a k^{th} NMOS transistor Q2ₖ of the m NMOS transistors Q2 are connected to the k^{th} signal output end 5aₖ. Both a drain d1ₘ of an m^{th} PMOS transistor Q1ₘ of the m PMOS transistors Q1 and a drain d2 of each of the m NMOS transistors Q2 are connected to the signal input end 6a of the target power domain circuit 6.

Referring to FIG. 4C, a source s1₁ of a first PMOS transistor Q1₁ of the m PMOS transistors Q1 is connected to the power supply of the power domain circuit to which the target signal output end 5at belongs, the m PMOS transistors Q1 are connected in series, a source s2 of each of the m NMOS transistors Q2 is connected to the reference ground of the target power domain circuit 6. Alternatively, referring to FIG. 4D, a source s1₁ of a first PMOS transistor Q1₁ is connected to the power supply of the target power domain circuit 6, the m PMOS transistors Q1 are connected in series, and a source s2ₖ of the k^{th} NMOS transistor Q2ₖ is connected to the reference ground of the power domain circuit to which the k^{th} signal output end 5aₖ belongs.

It should be noted that when the source s1₁ of the first PMOS transistor Q1₁ of the m PMOS transistors Q1 is connected to the power supply of the power domain circuit to which the target signal output end 5at of the m signal output ends 5a belongs, the m PMOS transistors Q1 are connected in series, and the source s2 of each of the m NMOS transistors Q2 is connected to the reference ground of the target power domain circuit 6, if a signal transmitted by the target signal output end 5at to the target input end 7aₜ of the NOR gate circuit 7 is at a logical high level, voltages applied to a gate g1ₜ of a target PMOS transistor Q1ₜ of the m PMOS transistors Q1 connected to the target signal output end 5at and a gate g2ₜ of a target NMOS transistor Q2ₜ of the m NMOS transistors Q2 are the voltage of the power supply of the power domain circuit to which the target signal output end 5at belongs. In this case, the voltage of the gate g1ₜ of the target PMOS transistor Q1ₜ is equal to a voltage of a source s1ₜ of the target PMOS transistor Q1ₜ, and the target PMOS transistor Q1ₜ is cut off. When a voltage, after increasing, of the reference ground of the target power domain circuit 6 does not exceed the voltage of the power supply of the power domain circuit to which the target signal output end 5at belongs, the voltage of the gate g2ₜ of the target NMOS transistor Q2ₜ is greater than a voltage of a source s2₁ of the target NMOS transistor Q2ₜ, and the target NMOS transistor Q2ₜ is turned on.

Therefore, when a signal transmitted by the target signal output end 5aₜ to the target input end 7at of the NOR gate circuit 7 is at a logical high level, provided that a voltage, after increasing, of the reference ground of the target power domain circuit 6 does not exceed the voltage of the power supply of each of the plurality of power domain circuits 5, the m PMOS transistors Q1 are all cut off, and the m NMOS transistors Q2 are all turned on. In this way, a voltage of a connection point between the drain d1ₘ of the m^{th} PMOS transistor Q1ₘ and the drain d2 of each of the m NMOS transistors Q2 is the voltage of the reference ground of the target power domain circuit 6 connected to the source s2ₜ of the target NMOS transistor Q2ₜ. To be specific, a voltage of a signal that is input to the signal input end 6a of the target power domain circuit 6 is the voltage of the reference ground of the target power domain circuit 6.

In addition, when the source s1ₗ of the first PMOS transistor Q1ₗ is connected to the power supply of the target power domain circuit 6, the m PMOS transistors Q1 are connected in series, and the source s2ₖ of the k^{th} NMOS transistor Q2ₖ is connected to the reference ground of the power domain circuit to which the k^{th} signal output end 5aₖ belongs, if a signal transmitted by the k^{th} signal output end 5aₖ to the k^{th} input end 7aₖ of the NOR gate circuit 7 is at a logical low level, voltages applied to the gate g1ₖ of the k^{th} PMOS transistor Q1ₖ and the gate g2ₖ of the k^{th} NMOS transistor Q2ₖ are the voltage of the reference ground of the power domain circuit to which the k^{th} signal output end 5aₖ belongs. In other words, the voltage of the gate g2ₖ of the k^{th} NMOS transistor Q2ₖ is equal to a voltage of the source s2ₖ of the k^{th} NMOS transistor Q2ₖ, and the k^{th} NMOS transistor Q2ₖ is cut off. When a voltage, after decreasing, of the power supply of the target power domain circuit 6 is not smaller than the voltage of the reference ground of the power domain circuit to which the k^{th} signal output end 5aₖ belongs, the voltage of the gate g1ₖ of the k^{th} PMOS transistor Q1ₖ is less than a voltage of a source s1ₖ of the k^{th} PMOS transistor Q1ₖ, and the k^{th} PMOS transistor Q1ₖ is turned on.

Therefore, when signals transmitted by the m signal output ends 5a to the m input ends 7a of the NOR gate circuit 7 are all at a logical low level, provided that a voltage, after decreasing, of the power supply of the target power domain circuit 6 is not smaller than the voltage of the reference ground of each of the plurality of power domain circuits 5, the m NMOS transistors Q2 are all cut off, and the m PMOS transistors Q1 are all conducted. In this way, the voltage of the connection point between the drain d1ₘ of the m^{th} PMOS transistor Q1ₘ and the drain d2 of each NMOS transistor Q2 of the m NMOS transistors Q2 is the voltage of the power supply of the target power domain circuit 6 connected to the source s1ₘ of the m^{th} PMOS transistor Q1ₘ. To be specific, a voltage of a signal that is input to the signal input end 6a of the target power domain circuit 6 is the voltage of the power supply of the target power domain circuit 6.

In this embodiment of the present invention, the m input ends of the NOR gate circuit are respectively connected to the m signal output ends of the plurality of power domain circuits, and the output end of the NOR gate circuit is connected to the signal input end of the target power domain circuit. In this case, if the power end of the NOR gate circuit is connected to the power supply of the power domain circuit to which the target signal output end of the m signal output ends belongs, and the m ground ends of the NOR gate circuit are all connected to the reference ground of the target power domain circuit, when a signal transmitted by the target signal output end of the m signal output ends to the target input end of the m input ends of the NOR gate circuit is at a logical high level, the voltage of the target input end of the NOR gate circuit is equal to the voltage of the power end of the NOR gate circuit. Therefore, even if the voltage of the reference ground of the target power domain circuit changes greatly due to electrostatic interference, provided that a voltage, after increasing, of the reference ground of the target power domain circuit does not exceed the voltage of the power supply of each of the plurality of power domain circuits, the voltage of the power end of the NOR gate circuit is greater than the voltage of each of the m ground ends of the NOR gate circuit, and the voltage of the target input end of the NOR gate circuit is greater than the turnover voltage of the NOR gate circuit. In this case, a voltage of a signal transmitted by the output end of the NOR gate circuit to the signal input end of the target power domain circuit is the voltage of the reference ground of the target power domain circuit. In this way, the signal that is input to the signal input end of the target power domain circuit is at a logical low level in the target power domain circuit, thereby ensuring correct transmission of the logical level of the signal. If the power end of the NOR gate circuit is connected to the power supply of the target power domain circuit, and the k^{th} ground end of the m ground ends of the NOR gate circuit is connected to the reference ground of the power domain circuit to which the k^{th} signal output end of the m signal output ends belongs, when signals transmitted by the m signal output ends to the m input ends of the NOR gate circuit are all at a logical low level, the voltage of the k^{th} input end of the NOR gate circuit is equal to the voltage of the k^{th} ground end of the NOR gate circuit. Therefore, even if the voltage of the power supply of the target power domain circuit changes greatly due to electrostatic interference, provided that a voltage, after decreasing, of the power supply of the target power domain circuit is not smaller than the voltage of the reference ground of each of the plurality of power domain circuits, the voltage of the power end of the NOR gate circuit is greater than the voltage of each of the m ground ends of the NOR gate circuit, and the voltage of each of the m input ends of the NOR gate circuit is less than the turnover voltage of the NOR gate circuit. In this case, a voltage of a signal transmitted by the output end of the NOR gate circuit to the signal input end of the target power domain circuit is the voltage of the power supply of the target power domain circuit. In this way, the signal that is input to the signal input end of the target power domain circuit is at a logical high level in the target power domain circuit, thereby ensuring correct transmission of the logical level of the signal.

The foregoing descriptions are merely embodiments provided in this application, but are not intended to limit this application. Any modification, equivalent replacement, or improvement made without departing from the principle of this application should fall within the protection scope of this application.

## Claims

1. An interface circuit, wherein the interface circuit comprises a NAND gate circuit, wherein
n input ends of the NAND gate circuit are respectively connected to n signal output ends of a plurality of power domain circuits, and an output end of the NAND gate circuit is connected to a signal input end of a target power domain circuit, wherein the n input ends of the NAND gate circuit one-to-one correspond to n power ends of the NAND gate circuit, and n is an integer greater than or equal to 2; and
an i^{th} power end of the n power ends of the NAND gate circuit is connected to a power supply of a power domain circuit to which an i^{th} signal output end of the n signal output ends belongs, a ground end of the NAND gate circuit is connected to a reference ground of the target power domain circuit, and i is an integer greater than or equal to 1 and less than or equal to n; or the n power ends of the NAND gate circuit are all connected to a power supply of the target power domain circuit, and a ground end of the NAND gate circuit is connected to a reference ground of a power domain circuit to which a target signal output end of the n signal output ends belongs, and the target signal output end is connected to a target input end of the n input ends of the NAND gate circuit.

2. The interface circuit according to claim 1, wherein the NAND gate circuit comprises n positive channel metal oxide semiconductor PMOS transistors and n negative channel metal oxide semiconductor NMOS transistors, wherein
both a gate of an i^{th} PMOS transistor of the n PMOS transistors and a gate of an i^{th} NMOS transistor of the n NMOS transistors are connected to the i^{th} signal output end, and both a drain of each of the n PMOS transistors and a drain of a first NMOS transistor of the n NMOS transistors are connected to the signal input end of the target power domain circuit; and
a source of the i^{th} PMOS transistor is connected to the power supply of the power domain circuit to which the i^{th} signal output end belongs, the n NMOS transistors are connected in series, and a source of an n^{th} NMOS transistor of the n NMOS transistors is connected to the reference ground of the target power domain circuit; or a source of each of the n PMOS transistors is connected to the power supply of the target power domain circuit, the n NMOS transistors are connected in series, and a source of the n^{th} NMOS transistor is connected to the reference ground of the power domain circuit to which the target signal output end belongs.

3. An interface circuit, wherein the interface circuit comprises a NOR gate circuit, wherein
m input ends of the NOR gate circuit are respectively connected to m signal output ends of a plurality of power domain circuits, and an output end of the NOR gate circuit is connected to a signal input end of a target power domain circuit, wherein the m input ends of the NOR gate circuit one-to-one correspond to m ground ends of the NOR gate circuit, and m is an integer greater than or equal to 2; and
a power end of the NOR gate circuit is connected to a power supply of a power domain circuit to which a target signal output end of the m signal output ends belongs, the m ground ends of the NOR gate circuit are all connected to a reference ground of the target power domain circuit, and the target signal output end is connected to a target input end of the m input ends of the NOR gate circuit; or a power end of the NOR gate circuit is connected to a power supply of the target power domain circuit, a k^{th} ground end of the m ground ends of the NOR gate circuit is connected to a reference ground of a power domain circuit to which a k^{th} signal output end of the m signal output ends belongs, and k is an integer greater than or equal to 1 and less than or equal to m.

4. The interface circuit according to claim 3, wherein the NOR gate circuit comprises m positive channel metal oxide semiconductor PMOS transistors and m negative channel metal oxide semiconductor NMOS transistors, wherein
both a gate of a k^{th} PMOS transistor of the m PMOS transistors and a gate of a k^{th} NMOS transistor of the m NMOS transistors are connected to the k^{th} signal output end, and both a drain of an m^{th} PMOS transistor of the m PMOS transistors and a drain of each of the m NMOS transistors are connected to the signal input end of the target power domain circuit; and
a source of a first PMOS transistor of the m PMOS transistors is connected to the power supply of the power domain circuit to which the target signal output end belongs, the m PMOS transistors are connected in series, and a source of each of the m NMOS transistors is connected to the reference ground of the target power domain circuit; or a source of the first PMOS transistor is connected to the power supply of the target power domain circuit, the m PMOS transistors are connected in series, and a source of the k^{th} NMOS transistor is connected to the reference ground of the power domain circuit to which the k^{th} signal output end belongs.
